# EUROPEAN PATENT SPECIFICATION

(11) **EP 4 454 434 B1**
(45) Date of publication and mention of the grant of the patent: **03.06.2026**
(21) Application number: 22829664.6
(22) Date of filing: 23.11.2022
(51) Int. Cl.: H10B 43/27, H10B 43/40, H10B 43/50

(54) **THREE-DIMENSIONAL MEMORY DEVICES AND FABRICATING METHODS THEREOF**
DREIDIMENSIONALE SPEICHERVORRICHTUNGEN UND HERSTELLUNGSVERFAHREN DAFÜR
DISPOSITIFS DE MÉMOIRE TRIDIMENSIONNELS ET PROCÉDÉS DE FABRICATION ASSOCIÉS

(43) Date of publication of application: 30.10.2024
(73) Proprietor: Yangtze Memory Technologies Co., Ltd., Wuhan, Hubei 430000 (CN)
(72) Inventor: ZHANG, Kun, Wuhan, Hubei 430000 (CN); ZHOU, Wenxi, Wuhan, Hubei 430000 (CN); WANG, Di, Wuhan, Hubei 430000 (CN); XUE, Lei, Wuhan, Hubei 430000 (CN)
(74) Representative: Lippert Stachow Patentanwälte Rechtsanwälte
(86) International application number: PCT/CN2022/133784
(87) International publication number: WO 2024/108435

(56) References cited:
- CN-A- 114 144 882
- US-A1- 2019 252 396
- US-A1- 2020 043 830
- US-A1- 2023 110 729

## Description

### TECHNICAL FIELD

The present disclosure generally relates to the field of semiconductor technology, and more particularly, to a three-dimensional (3D) memory device and a fabricating method thereof.

### BACKGROUND

With continuous rising and development of artificial intelligence (AI), big data, Internet of Things, mobile devices and communications, and cloud storage, etc., the demand for memory capacity are growing in an exponential way. Compared with other non-volatile memories, NAND memory has many advantages, such as high integration, low power consumption, fast programming/erasing speed, good reliability, low cost, etc., and thus has gradually become the mainstream semiconductor memory in the industry.

Planar NAND memory cells are scaled to smaller sizes by improving process technology, circuit design, programming algorithm, and fabrication process. However, as feature sizes of the memory cells approach a lower limit, planar process and fabrication techniques become challenging and costly. As a result, memory density for planar memory cells approaches an upper limit.

A three-dimensional (3D) NAND memory architecture can address the density limitation in planar memory cells. The 3D memory architecture includes a memory array and periphery devices for controlling signals to and from the memory array.

CN 114 144 882 discloses a three-dimensional memory device according to the preamble of claim 1. US 2020/043830 shows further relevant art.

### SUMMARY

A three-dimensional memory device according to the invention is presented in claim 1. Embodiments of the invention are presented in the dependent claims. In one aspect, a method for forming a three-dimensional (3D) memory device is disclosed. The method comprises: forming a first semiconductor structure including a core region, a spacer region, and a periphery region, comprising: forming a first periphery circuit on a first substrate in the periphery region, forming a memory stack on the first substrate in the core region, and forming a spacer structure in the spacer region to separate the memory stack and the first periphery circuit; forming a second semiconductor structure including a second periphery circuit on a second substrate; bonding the second semiconductor structure to the first semiconductor structure; and forming a supplemental semiconductor layer to replace a portion of the first substrate in the core region.

In some implementations, forming the first semiconductor structure further comprises: after forming the first periphery circuit and before forming the memory stack, removing a first portion of the first substrate in the core region and the spacer region, such that an offsite is formed on the remaining portion of the first substrate between the periphery region and the spacer region.

In some implementations, forming the first semiconductor structure further comprises: forming a sacrificial stack to cover the first substrate in the core region and the spacer region, and to cover the first periphery circuit in the periphery region; forming a dielectric stack structure to cover the sacrificial stack in the core region, the spacer region, and the periphery region; and removing a portion of the sacrificial stack and the dielectric stack structure in the periphery region.

In some implementations, forming the sacrificial stack comprises: forming a first stop layer to cover the first substrate in the core region and the spacer region, and to cover the first periphery circuit in the periphery region; forming a sacrificial semiconductor layer to cover the first stop layer; forming a second stop layer to cover the first stop layer; and forming a barrier layer to cover the second stop layer.

In some implementations, forming the first semiconductor structure further comprises: removing portions of the dielectric stack structure in the core region to form a staircase structure, such that a remaining portion of the dielectric stack structure including a turning structure in the spacer region forms the spacer structure.

In some implementations, forming the first semiconductor structure further comprises: forming a plurality of channel structures penetrating the dielectric stack structure and extending into the sacrificial stack in the core region, each channel structure including a functional layer and a semiconductor channel.

In some implementations, forming the first semiconductor structure further comprises: forming a plurality of dummy channel structures penetrating the dielectric stack structure and extending into the sacrificial stack in the core region.

In some implementations, forming the first semiconductor structure further comprises: forming at least one slit penetrating the dielectric stack structure and extending into the sacrificial stack in the core region; and converting the dielectric stack structure into the memory stack.

In some implementations, forming the dielectric stack structure comprises forming a plurality of dielectric layer pairs stacked on the sacrificial stack, each dielectric layer pair including a stack sacrificial layer and a stack dielectric layer different from the stack sacrificial layer.

In some implementations, converting the dielectric stack structure into the memory stack comprises removing the plurality of stack sacrificial layers in the dielectric stack structure through the slits to form a plurality of trenches; and forming a gate structure in each trench.

In some implementations, forming the first semiconductor structure further comprises: forming a plurality of word line contacts, a plurality of channel structure contacts in the core region; forming a plurality of periphery contacts in the periphery region; and forming a plurality of first interconnect contacts connected with corresponding word line contacts, channel structure contacts, and periphery contacts, respectively.

In some implementations, forming the first periphery circuit comprises forming a high voltage circuit including a plurality of high voltage transistors on the first substrate in the periphery region.

In some implementations, forming the first periphery circuit further comprises forming a low voltage circuit including a plurality of low voltage transistors on the first substrate in the periphery region.

In some implementations, forming the second periphery circuit comprises: forming a low low voltage circuit including a plurality of low low voltage transistors on the second substrate; and forming a plurality of second interconnect contacts connected with corresponding low low voltage transistors, respectively.

In some implementations, forming the second periphery circuit further comprises forming a low voltage circuit including a plurality of low voltage transistors on the second substrate.

In some implementations, bonding the second semiconductor structure to the first semiconductor structure comprises mbonding the second semiconductor structure to the first semiconductor structure in a face-to-face manner to connect the second interconnect contacts to corresponding second interconnect contacts respectively.

In some implementations, forming the supplemental semiconductor layer to replace the portion of the first substrate in the core region comprises: removing a second portion of the first substrate and stopping at the first stop layer, such that a third portion of the first substrate in the periphery region is maintained; forming a protection layer on the third portion of the first substrate in the periphery region; removing portions of the sacrificial semiconductor layer in the core region and stopping at the second stop layer to expose portions of the channel structures; removing a portion of the functional layer of each channel structure to expose the semiconductor channel; and doping a portion of the semiconductor channel of each channel structure.

In some implementations, removing the portion of the functional layer of each channel structure comprises: removing portions of a blocking layer, a storage layer, and a tunneling layer of each channel structure that are located above the barrier layer; and simultaneously removing the second stop layer in the core region and the protection layer in the periphery region.

In some implementations, forming the supplemental semiconductor layer to replace the portion of the first substrate in the core region comprises: forming the supplemental semiconductor layer in the core region to electrically connect with the doped portion of the semiconductor channel of each channel structure; and performing a local thermal treatment to portions of the supplemental semiconductor layer in the core region without affecting the remaining portion of the first substrate in the periphery region.

In some implementations, the method further comprises forming a pad layer on the supplemental semiconductor layer, comprising: forming a pad dielectric layer on the supplemental semiconductor layer in the core region and on the remaining portion of the first substrate in the periphery region; forming a plurality of pad structures embedded in the pad dielectric layer; forming a wiring layer on the pad dielectric layer to connect with the plurality of pad structures; and forming a passivation layer to cover the wiring layer.

Another aspect of the present disclosure provides a three-dimensional (3D) memory device, according to the invention, comprising: a first semiconductor structure including a core region, a spacer region, and a periphery region, comprising: a memory stack on a semiconductor layer in the core region, a first periphery circuit on the semiconductor layer in the periphery region, and a spacer structure in the spacer region to separate the memory stack and the first periphery circuit; and a second semiconductor structure including a second periphery circuit on a substrate; wherein the second semiconductor structure is connected to the first semiconductor structure. The spacer structure comprises a dielectric stack structure in the spacer region, the dielectric stack structure including a plurality of dielectric layer pairs each including a stack sacrificial layer and a stack dielectric layer different from the stack sacrificial layer. The spacer structure comprises a turning structure comprises a first portion of the plurality of dielectric layer pairs extending in a horizontal plane and a second portion of the plurality of dielectric layer pairs extending in a non-horizontal plane. The memory stack comprises a staircase structure.

In some implementations, the first semiconductor structure further comprises a plurality of channel structures penetrating the memory stack in the core region, each channel structure including a functional layer and a semiconductor channel.

In some implementations, the first semiconductor structure further comprises: a plurality of dummy channel structures penetrating the staircase structure in the core region.

In some implementations, the first semiconductor structure further comprises at least one slit structure penetrating the memory stack and extending in a parallel direction to separate the plurality of channel structures.

In some implementations, the memory stack comprises a plurality of interleaved stack dielectric layers and gate structures stacked in a vertical direction.

In some implementations, the first semiconductor structure further comprises: a plurality of word line contacts, a plurality of channel structure contacts in the core region; a plurality of periphery contacts in the periphery region; and a plurality of first interconnect contacts connected with corresponding word line contacts, channel structure contacts, and periphery contacts, respectively.

In some implementations, the first periphery circuit comprises a high voltage circuit including a plurality of high voltage transistors on the semiconductor layer in the periphery region.

In some implementations, the first periphery circuit further comprises a low voltage circuit including a plurality of low voltage transistors on the semiconductor layer in the periphery region.

In some implementations, the second periphery circuit comprises: a low low voltage circuit including a plurality of low low voltage transistors on the substrate; and a plurality of second interconnect contacts connected with corresponding low low voltage transistors, respectively.

In some implementations, the second periphery circuit further comprises a low voltage circuit including a plurality of low voltage transistors on the substrate.

In some implementations, the second semiconductor structure and the first semiconductor structure are bonded together in a face-to-face manner, such that the second interconnect contacts and corresponding second interconnect contacts are connected respectively at a bonding interface.

In some implementations, the functional layer of each channel structure comprises a blocking layer, a storage layer, and a tunneling layer; and the semiconductor channel comprises a doped region contacting the semiconductor layer.

In some implementations, the device further comprises a pad layer on the semiconductor layer, the pad layer comprising: a pad dielectric layer on the semiconductor layer; a plurality of pad structures embedded in the pad dielectric layer; a wiring layer on the pad dielectric layer to connect with the plurality of pad structures; and a passivation layer to cover the wiring layer.

In some implementations, the semiconductor layer comprises: an initial semiconductor layer in the periphery region; and a supplemental semiconductor layer in the core region and the spacer region; wherein the initial semiconductor layer is isolated from the supplemental semiconductor layer by a spacer layer.

Another aspect of the present disclosure provides a memory system, comprising: a memory device configured to store data, and comprising: a first semiconductor structure including a core region, a spacer region, and a periphery region, comprising: a memory stack including an array of memory cells on a semiconductor layer in the core region, a first periphery circuit on the semiconductor layer in the periphery region, and a spacer structure in the spacer region to separate the memory stack and the first periphery circuit, and a second semiconductor structure including a second periphery circuit on a substrate, wherein the second semiconductor structure is bonded with the first semiconductor structure at a bonding interface; and a memory controller coupled to the memory device and configured to control the array of memory cells through the first peripheral circuit and the second periphery circuit.

Other aspects of the present disclosure can be understood by those skilled in the art in light of the description, the claims, and the drawings of the present disclosure.

### BRIEF DESCRIPTION OF THE DRAWINGS

The accompanying drawings, which are incorporated herein and form a part of the specification, illustrate aspects of the present disclosure and, together with the description, further serve to explain the principles of the present disclosure and to enable a person skilled in the pertinent art to make and use the present disclosure.
FIG. 1 illustrates a schematic diagram of a cross-section of an exemplary 3D memory device, according to some aspects of the present disclosure.
FIG. 2 illustrates a schematic circuit diagram of an exemplary memory device, according to some aspects of the present disclosure.
FIG. 3 illustrates a schematic circuit diagram of an exemplary memory device, according to some aspects of the present disclosure.
FIG. 4A illustrates a block diagram of periphery circuits provided with various voltages, according to some aspects of the present disclosure.
FIG. 4B illustrates a schematic diagram of a cross-section of an exemplary 3D memory device including periphery circuits with various voltages, according to some aspects of the present disclosure.
FIG. 5 illustrates a side view of a cross-section of an exemplary 3D memory device 500, according to some aspects of the present disclosure.
FIG. 6 illustrates a block diagram of an exemplary system having a 3D memory device, according to some aspects of the present disclosure.
FIG. 7A illustrates a diagram of an exemplary memory card having a 3D memory device, according to some aspects of the present disclosure.
FIG. 7B illustrates a diagram of an exemplary solid-state drive (SSD) having a 3D memory device, according to some aspects of the present disclosure.
FIGs. 8A and 8B illustrate flow diagrams of an exemplary method for forming a 3D memory device, according to s some aspects of the present disclosure.
FIGs. 9A-9J illustrate schematic cross-sectional views of an exemplary 3D memory device at certain fabricating stages of the method shown in FIG. 8A, according to some aspects of the present disclosure.
FIGs. 10A-10I illustrate schematic cross-sectional views of an exemplary 3D memory device at certain fabricating stages of the method shown in FIG. 8B, according to some aspects of the present disclosure.

The present disclosure will be described with reference to the accompanying drawings.

### DETAILED DESCRIPTION

Although specific configurations and arrangements are discussed, it should be understood that this is done for illustrative purposes only. As such, other configurations and arrangements can be used without departing from the scope of the present disclosure. Also, the present disclosure can also be employed in a variety of other applications. Functional and structural features as described in the present disclosures can be combined, adjusted, and modified with one another and in ways not specifically depicted in the drawings, such that these combinations, adjustments, and modifications are within the scope of the present disclosure.

In general, terminology may be understood at least in part from usage in context. For example, the term "one or more" as used herein, depending at least in part upon context, may be used to describe any feature, structure, or characteristic in a singular sense or may be used to describe combinations of features, structures or characteristics in a plural sense. Similarly, terms, such as "a," "an," or "the," again, may be understood to convey a singular usage or to convey a plural usage, depending at least in part upon context. In addition, the term "based on" may be understood as not necessarily intended to convey an exclusive set of factors and may, instead, allow for existence of additional factors not necessarily expressly described, again, depending at least in part on context.

It should be readily understood that the meaning of "on," "above," and "over" in the present disclosure should be interpreted in the broadest manner such that "on" not only means "directly on" something but also includes the meaning of "on" something with an intermediate feature or a layer therebetween, and that "above" or "over" not only means the meaning of "above" or "over" something but can also include the meaning it is "above" or "over" something with no intermediate feature or layer therebetween (i.e., directly on something).

Further, spatially relative terms, such as "beneath," "below," "lower," "above," "upper," and the like, may be used herein for ease of description to describe one element or feature's relationship to another element(s) or feature(s) as illustrated in the figures. The spatially relative terms are intended to encompass different orientations of the device in use or operation in addition to the orientation depicted in the figures. The apparatus may be otherwise oriented (rotated 90 degrees or at other orientations), and the spatially relative descriptors used herein may likewise be interpreted accordingly.

As used herein, the term "substrate" refers to a material onto which subsequent material layers are added. The substrate itself can be patterned. Materials added on top of the substrate can be patterned or can remain unpatterned. Furthermore, the substrate can include a wide array of semiconductor materials, such as silicon, germanium, gallium arsenide, indium phosphide, etc. Alternatively, the substrate can be made from an electrically non-conductive material, such as a glass, a plastic, or a sapphire wafer.

As used herein, the term "layer" refers to a material portion including a region with a thickness. A layer can extend over the entirety of an underlying or overlying structure or may have an extent less than the extent of an underlying or overlying structure. Further, a layer can be a region of a homogeneous or inhomogeneous continuous structure that has a thickness less than the thickness of the continuous structure. For example, a layer can be located between any pair of horizontal planes between, or at, a top surface and a bottom surface of the continuous structure. A layer can extend horizontally, vertically, and/or along a tapered surface. A substrate can be a layer, can include one or more layers therein, and/or can have one or more layers thereupon, thereabove, and/or therebelow. A layer can include multiple layers. For example, an interconnect layer can include one or more conductors and contact layers (in which interconnect lines and/or vertical interconnect access (via) contacts are formed) and one or more dielectric layers. It is noted that, the term "contact" refers to a conductive structure connecting between to conductive components.

As semiconductor technology advances, three-dimensional (3D) memory devices, such as 3D NAND memory devices, keep scaling more oxide/nitride (ON) layers of the memory cell array. With the increase of the number of array layers of the 3D architecture, the CMOS periphery circuit needs more complex and size scaling. For example, a complementary metal-oxide-semiconductor wafer ("CMOS wafer" hereinafter) is bonded with a memory cell array wafer ("array wafer" hereinafter) to form a framework of the 3D memory device. In order to achieve optimization of area, the CMOS driver circuit can be divided into two parts: a high-voltage driver part and an input/output (I/O) logic part. However, those architectures of the 3D NAND array and CMOS periphery circuits restrict the performance of the 3D NAND memory devices.

Accordingly, new 3D memory devices and fabricating methods thereof are provided to address such issues. It is noted that, the 3D memory device can be a part of a non-monolithic 3D memory device, in which components (e.g., portions of the CMOS devices and the memory cell array device) are formed separately on different wafers and then bonded in a face-to-face manner. In some implementations, as described below in connection with the figures, a first wafer including the memory cell array is flipped and faces down towards a second wafer for hybrid bonding, so that in the bonded non-monolithic 3D memory device, the first wafer is above the second wafer. It is understood that in some other implementations, the first wafer remains as the substrate of the bonded non-monolithic 3D memory device, and the second wafer is flipped and faces down towards the first wafer for hybrid bonding.

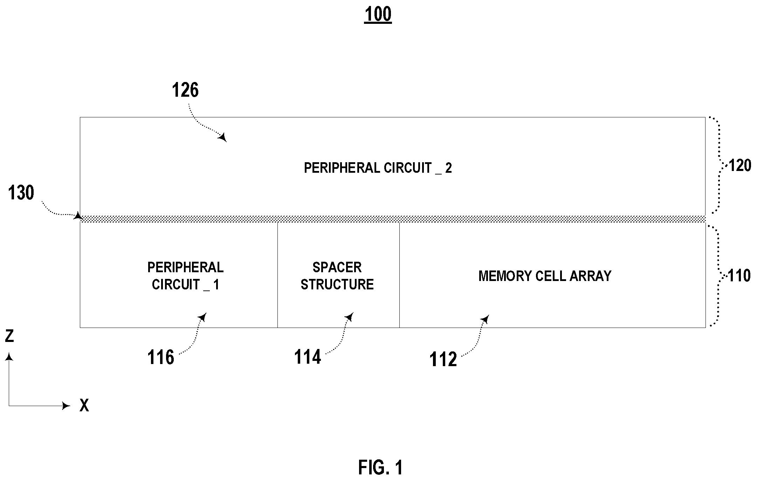

FIG. 1 illustrates a schematic view of a cross-section of a 3D memory device 100, according to some aspects of the present disclosure. 3D memory device 100 represents an example of a bonded chip. In some implementations, at least some of the components of 3D memory device 100 (e.g., first wafer/first semiconductor structure 110 and second wafer/second semiconductor structure 120 as shown in FIG. 1) are formed separately on different substrates in parallel and then jointed to form a bonded chip (a process referred to herein as a "parallel process").

It is noted that X and Z axes are added in FIG. 1 to further illustrate the spatial relationships of the components of a semiconductor device. A substrate of a semiconductor device, e.g., 3D memory device 100, includes two lateral surfaces (e.g., a top surface and a bottom surface) extending laterally in the x- direction (e.g., bit line direction). As used herein, whether one component (e.g., a layer or a device) is "on," "above," or "below" another component (e.g., a layer or a device) of a semiconductor device is determined relative to the substrate of the semiconductor device in the Z direction (the vertical direction or thickness direction) when the substrate is positioned in the lowest plane of the semiconductor device in the Z direction. The same notion for describing the spatial relationships is applied throughout the present disclosure.

3D memory device 100 can include a first semiconductor structure 110 including an array of memory cells (also referred to herein as a "memory cell array 112") and a first periphery circuit 116 of the memory cell array 112. In some implementations, the memory cell array 112 includes an array of NAND Flash memory cells. For ease of description, a NAND Flash memory cell array may be used as an example for describing the memory cell array 112 in the present disclosure. But it is understood that the memory cell array 112 is not limited to NAND Flash memory cell array and may include any other suitable types of memory cell arrays, such as NOR Flash memory cell array, phase change memory (PCM) cell array, resistive memory cell array, magnetic memory cell array, spin transfer torque (STT) memory cell array, to name a few.

First semiconductor structure 110 can include a NAND Flash memory device in which memory cells are provided in the form of an array of 3D NAND memory strings and/or an array of two-dimensional (2D) NAND memory cells. NAND memory cells can be organized into pages or fingers, which are then organized into blocks in which each NAND memory cell is coupled to a separate line called a bit line (BL). All cells with the same vertical position in the NAND memory cell can be coupled through the control gates by a word line (WL). In some implementations, a memory plane contains a certain number of blocks that are coupled through the same bit line. First semiconductor structure 110 can include one or more memory planes.

In some implementations, the array of NAND memory cells is an array of 2D NAND memory cells, each of which includes a floating-gate transistor. The array of 2D NAND memory cells includes a plurality of 2D NAND memory strings, each of which includes a plurality of memory cells connected in series (resembling a NAND gate) and two select transistors, according to some implementations. Each 2D NAND memory string is arranged in the same plane (i.e., referring to herein a flat, two-dimensional (2D) surface, different from the term "memory plane" in the present discourse) on the substrate, according to some implementations. In some implementations, the array of NAND memory cells is an array of 3D NAND memory strings, each of which extends vertically above the substrate (in 3D) through a stack structure, e.g., a memory stack. Depending on the 3D NAND technology (e.g., the number of layers/tiers in the memory stack), a 3D NAND memory string typically includes a certain number of NAND memory cells, each of which includes a floating-gate transistor or a charge-trap transistor.

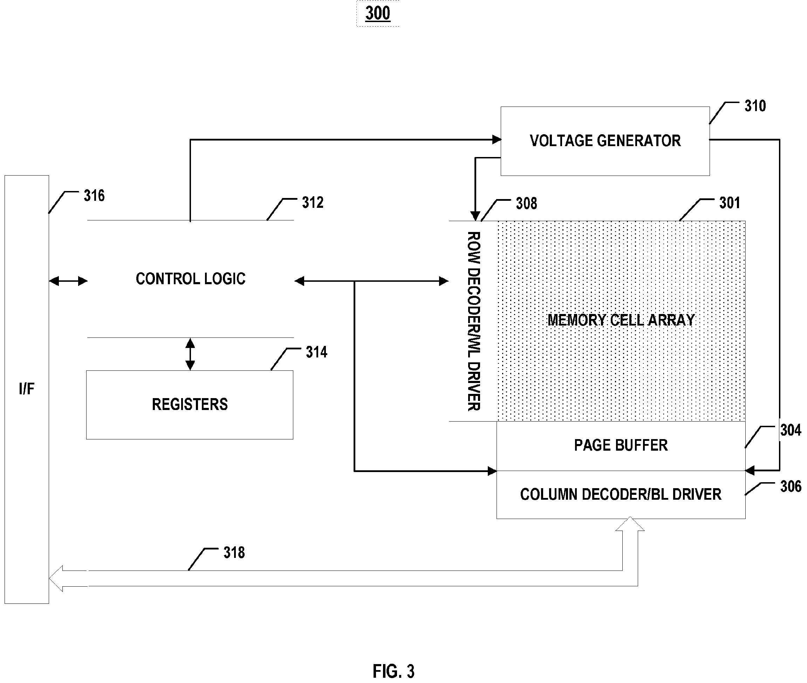

As shown in FIG. 1, 3D memory device 100 can also include some periphery circuits of the memory cell array to perform all the read/program (write)/erase operations. That is, the periphery circuits of the memory cell array can be separated into at least two other semiconductor structures (e.g., 110 and 120 in FIG. 1). The periphery circuits (a.k.a. control and sensing circuits) can include any suitable digital, analog, and/or mixed-signal circuits used for facilitating the operations of the memory cell array. For example, the periphery circuits can include one or more of a page buffer, a decoder (e.g., a row decoder and a column decoder), a sense amplifier, a driver (e.g., a word line driver), an I/O circuit, a charge pump, a voltage source or generator, a current or voltage reference, any portions (e.g., a sub-circuit) of the functional circuits mentioned above, or any active or passive components of the circuit (e.g., transistors, diodes, resistors, or capacitors). The periphery circuits in first semiconductor structure 110 and second semiconductor structure 120 can use CMOS technology, e.g., which can be implemented with logic processes in any suitable technology nodes.

As shown in FIG. 1, first semiconductor structure 110 and second semiconductor structure 120 are stacked in two different planes, according to some implementations. Memory cell array 112 and first periphery circuit 116 can be arranged in first semiconductor structure 110, and can be separated by spacer structure 114. Second periphery circuit can be arranged in second semiconductor structure 120, and can be stacked over first semiconductor structure 110 to reduce the planar size of 3D memory device 100, compared with memory devices in which all the periphery circuits are disposed in a same plane.

As shown in FIG. 1, 3D memory device 100 further includes a bonding interface 130 vertically between first semiconductor structure 110 and second semiconductor structure 120. Bonding interface 130 can be an interface between two semiconductor structures formed by any suitable bonding technologies as described below in detail, such as hybrid bonding, anodic bonding, fusion bonding, transfer bonding, adhesive bonding, and eutectic bonding, to name a few. In some implementations, as shown in FIG. 1, second semiconductor structure 120 is bonded to first semiconductor structure 110 on opposite sides thereof.

In some implementations, second semiconductor structure 120 does not include any memory cell. In other words, second semiconductor structure 120 only includes periphery circuits, but not the memory cell array, according to some implementations. As a result, the memory cell array can be only included in first semiconductor structure 110, but not second semiconductor structure 120.

As described below in detail, first semiconductor structure 110 and second semiconductor structure 120 can be fabricated separately (and in parallel in some implementations) by the parallel process, such that the thermal budget of fabricating one of first and second semiconductor structures 110 and 120 does not limit the processes of fabricating another one of first and second semiconductor structures 110 and 120. Moreover, a large number of interconnects (e.g., bonding contacts and/or inter-layer vias (ILVs)/through substrate vias (TSVs)) can be formed across bonding interface 130 to make direct, short-distance (e.g., micron- or submicron-level) electrical connections between first and second semiconductor structures 110 and 120, as opposed to the long-distance (e.g., millimeter or centimeter-level) chip-to-chip data bus on the circuit board, such as printed circuit board (PCB), thereby eliminating chip interface delay and achieving high-speed I/O throughput with reduced power consumption. Data transfer among the memory cell array and the different periphery circuits in first and second semiconductor structures 110 and 120 can be performed through the interconnects (e.g., bonding contacts and/or ILVs/TSVs) across bonding interface 130. By vertically integrating first and second semiconductor structures 110 and 120, the chip size can be reduced, and the memory cell density can be increased.

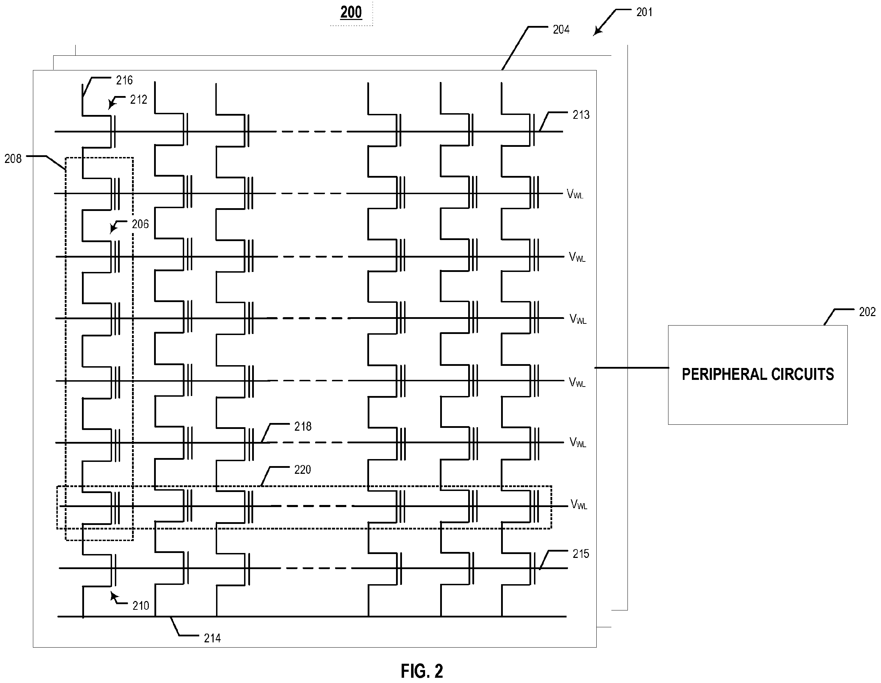

FIG. 2 illustrates a schematic circuit diagram of a memory device 200 including periphery circuits, according to some aspects of the present disclosure. Memory device 200 can include a memory cell array 201 and periphery circuits 202 coupled to memory cell array 201. 3D memory device 100 may be an example of memory device 200 in which memory cell array 201 and at least two portions of periphery circuits 202 may be included in first and second semiconductor structures 110 and 120. Memory cell array 201 can be a NAND Flash memory cell array in which memory cells 206 are provided in the form of an array of NAND memory strings 208 each extending vertically above a substrate (not shown). In some implementations, each NAND memory string 208 includes a plurality of memory cells 206 coupled in series and stacked vertically. Each memory cell 206 can hold a continuous, analog value, such as an electrical voltage or charge, that depends on the number of electrons trapped within a region of memory cell 206. Each memory cell 206 can be either a floating gate type of memory cell including a floating-gate transistor or a charge trap type of memory cell including a charge-trap transistor.

In some implementations, each memory cell 206 is a single-level cell (SLC) that has two possible memory states and thus, can store one bit of data. For example, the first memory state "0" can correspond to a first range of voltages, and the second memory state "1" can correspond to a second range of voltages. In some implementations, each memory cell 206 is a multi-level cell (MLC) that is capable of storing more than a single bit of data in more than four memory states. For example, the MLC can store two bits per cell, three bits per cell (also known as triple-level cell (TLC)), or four bits per cell (also known as a quad-level cell (QLC)). Each MLC can be programmed to assume a range of possible nominal storage values. In one example, if each MLC stores two bits of data, then the MLC can be programmed to assume one of three possible programming levels from an erased state by writing one of three possible nominal storage values to the cell. A fourth nominal storage value can be used for the erased state.

As shown in FIG. 2, each NAND memory string 208 can include a source select gate (SSG) transistor 210 at its source end and a drain select gate (DSG) transistor 212 at its drain end. SSG transistor 210 and DSG transistor 212 can be configured to activate selected NAND memory strings 208 (columns of the array) during read and program operations. In some implementations, SSG transistors 210 of NAND memory strings 208 in the same block 204 are coupled through a same source line (SL) 214. e.g., a common SL, for example, to the ground. DSG transistor 212 of each NAND memory string 208 is coupled to a respective bit line 216 from which data can be read or programmed via an output bus (not shown), according to some implementations. In some implementations, each NAND memory string 208 is configured to be selected or deselected by applying a select voltage (e.g., above the threshold voltage of DSG transistor 212) or a deselect voltage (e.g., 0 V) to respective DSG transistor 212 through one or more DSG lines 213 and/or by applying a select voltage (e.g., above the threshold voltage of SSG transistor 210) or a deselect voltage (e.g., 0 V) to respective SSG transistor 210 through one or more SSG lines 215.

As shown in FIG. 2, NAND memory strings 208 can be organized into multiple blocks 204, each of which can have a common source line 214. In some implementations, each block 204 is the basic data unit for erase operations, i.e., all memory cells 206 on the same block 204 are erased at the same time. Memory cells 206 of adjacent NAND memory strings 208 can be coupled through word lines 218 that select which row of memory cells 206 is affected by read and program operations. In some implementations, each word line 218 is coupled to a page 220 of memory cells 206, which is the basic data unit for program and read operations. The size of one page 220 in bits can correspond to the number of NAND memory strings 208 coupled by word line 218 in one block 204. Each word line 218 can include a plurality of control gates (gate electrodes) at each memory cell 206 in respective page 220 and a gate line coupling the control gates.

Referring to FIG. 2, periphery circuits 202 can be coupled to memory cell array 201 through bit lines 216, word lines 218, source lines 214, SSG lines 215, and DSG lines 213. As described above, periphery circuits 202 can include any suitable circuits for facilitating the operations of memory cell array 201 by applying and sensing voltage signals and/or current signals through bit lines 216 to and from each target memory cell 206 through word lines 218, source lines 214, SSG lines 215, and DSG lines 213. Periphery circuits 202 can include various types of periphery circuits formed using CMOS technologies. For example, FIG. 3 illustrates some exemplary periphery circuits 202 including a page buffer 304, a column decoder/bit line driver 306, a row decoder/word line driver 308, a voltage generator 310, control logic 312, registers 314, an interface (I/F) 316, and a data bus 318. It is understood that in some examples, additional periphery circuits 202 may be included as well.

Page buffer 304 can be configured to buffer data read from or programmed to memory cell array 201 according to the control signals of control logic 312. In one example, page buffer 304 may store one page of program data (write data) to be programmed into one page 220 of memory cell array 201. In another example, page buffer 304 also performs program verify operations to ensure that the data has been properly programmed into memory cells 206 coupled to selected word lines 218.

Row decoder/word line driver 308 can be configured to be controlled by control logic 312 and select block 204 of memory cell array 201 and a word line 218 of selected block 204. Row decoder/word line driver 308 can be further configured to drive memory cell array 201. For example, row decoder/word line driver 308 may drive memory cells 206 coupled to the selected word line 218 using a word line voltage generated from voltage generator 310.

Column decoder/bit line driver 306 can be configured to be controlled by control logic 312 and select one or more 3D NAND memory strings 208 by applying bit line voltages generated from voltage generator 310. For example, column decoder/bit line driver 306 may apply column signals for selecting a set of *N* bits of data from page buffer 304 to be outputted in a read operation.

Control logic 312 can be coupled to each periphery circuit 202 and configured to control operations of periphery circuits 202. Registers 314 can be coupled to control logic 312 and include status registers, command registers, and address registers for storing status information, command operation codes (OP codes), and command addresses for controlling the operations of each periphery circuit 202.

Interface 316 can be coupled to control logic 312 and configured to interface memory cell array 201 with a memory controller (not shown). In some implementations, interface 316 acts as a control buffer to buffer and relay control commands received from the memory controller and/or a host (not shown) to control logic 312 and status information received from control logic 312 to the memory controller and/or the host. Interface 316 can also be coupled to page buffer 304 and column decoder/bit line driver 306 via data bus 318 and act as an I/O interface and a data buffer to buffer and relay the program data received from the memory controller and/or the host to page buffer 304 and the read data from page buffer 304 to the memory controller and/or the host. In some implementations, interface 316 and data bus 318 are parts of an I/O circuit of periphery circuits 202.

Voltage generator 310 can be configured to be controlled by control logic 312 and generate the word line voltages (e.g., read voltage, program voltage, pass voltage, local voltage, and verification voltage) and the bit line voltages to be supplied to memory cell array 201. In some implementations, voltage generator 310 is part of a voltage source that provides voltages at various levels of different periphery circuits 202 as described below in detail. Consistent with the scope of the present disclosure, in some implementations, the voltages provided by voltage generator 310, for example, to row decoder/word line driver 308, column decoder/bit line driver 306, and page buffer 304 are above certain levels that are sufficient to perform the memory operations. For example, the voltages provided to the page buffer circuits in page buffer 304 and/or the logic circuits in control logic 312 may be between 1.3 V and 5 V, such as 3.3 V, and the voltages provided to the driving circuits in row decoder/word line driver 308 and/or column decoder/bit line driver 306 may be between 5 V and 30 V.

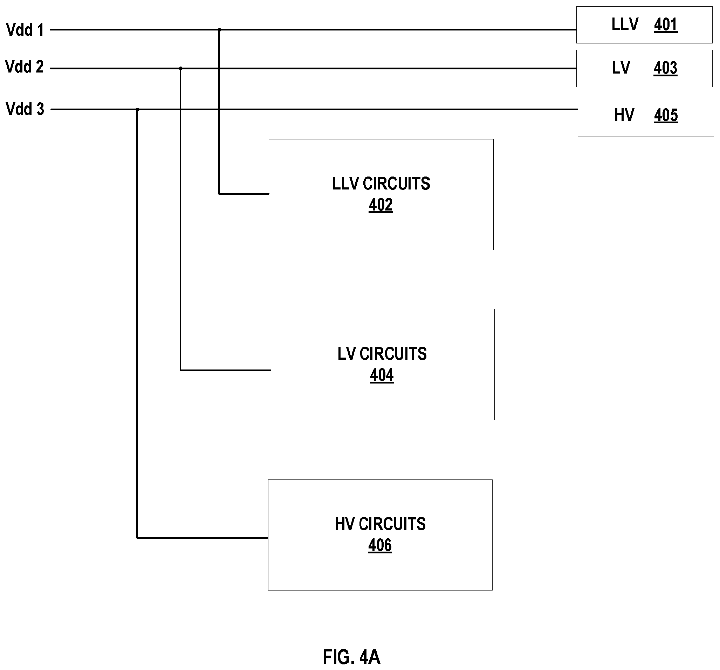

Different from logic devices (e.g., microprocessors), memory devices, such as 3D NAND Flash memory, require a wide range of voltages to be supplied to different memory periphery circuits. For example, FIG. 4A illustrates a block diagram of periphery circuits provided with various voltages, according to some aspects of the present disclosure. In some implementations, a memory device (e.g., memory device 200) includes a low low voltage (LLV) source 401, a low voltage (LV) source 403, and a high voltage (HV) source 405, each of which is configured to provide a voltage at a respective level (Vdd1, Vdd2, or Vdd3). For example, Vdd3 > Vdd2 > Vdd1. Each voltage source 401, 403, or 405 can receive a voltage input at a suitable level from an external power source (e.g., a battery). Each voltage source 401, 403, or 405 can also include voltage converters and/or voltage regulators to convert the external voltage input to the respective level (Vdd1, Vdd2, or Vdd3) and maintain and output the voltage at the respective level (Vdd1, Vdd2, or Vdd3) through a corresponding power rail. In some implementations, voltage generator 310 of memory device 200 is part of voltage sources 401, 403, and 405.

In some implementations, LLV voltage source 401 is configured to provide a voltage below 1.3 V, such as between 0.9 V and 1.2 V (e.g., 0.9 V, 0. 95 V, 1 V, 1.05 V, 1.1 V, 1.15 V, 1.2 V, any range bounded by the lower end by any of these values, or in any range defined by any two of these values). In one example, the voltage is 1.2 V. In some implementations, LV voltage source 403 is configured to provide a voltage between 1.3 V and 3.3 V (e.g., 1.3 V, 0. 1.4 V, 1.5 V, 1.6 V, 1.7 V, 1.8 V, 1.9 V, 2 V, 2.1 V, 2.2 V, 2.3 V, 2.4 V, 2.5 V, 2.6 V, 2.7 V, 2.8 V, 2.9 V, 3 V, 3.1 V, 3.2 V, 3.3 V, any range bounded by the lower end by any of these values, or in any range defined by any two of these values). In one example, the voltage is 3.3 V. In some implementations, HV voltage source 405 is configured to provide a voltage greater than 3.3 V, such as between 5 V and 30 V (e.g., 5 V, 6 V, 7 V, 8 V, 9 V, 10 V, 11 V, 12 V, 13 V, 14 V, 15 V, 16 V, 17 V, 18 V, 19 V, 20 V, 21 V, 22 V, 23 V, 24 V, 25 V, 26 V, 27 V, 28 V, 29 V, 30 V, any range bounded by the lower end by any of these values, or in any range defined by any two of these values). It is understood that the voltage ranges described above with respect to HV voltage source 405, LV voltage source 403, and LLV voltage source 401 are for illustrative purposes and non-limiting, and any other suitable voltage ranges may be provided by HV voltage source 405, LV voltage source 403, and LLV voltage source 401.

Based on their suitable voltage levels (Vdd1, Vdd2, or Vdd3), the memory periphery circuits (e.g., periphery circuits 202) can be categorized into LLV circuits 402, LV circuits 404, and HV circuits 406, which can be coupled to LLV voltage source 401, LV voltage source 403, and HV voltage source 405, respectively. In some implementations, HV circuits 406 includes one or more driving circuits that are coupled to the memory cell array (e.g., memory cell array 201) through word lines, bit lines, SSG lines, DSG lines, source lines, etc., and configured to drive the memory cell array by applying a voltage at a suitable level to the word lines, bit lines, SSG lines, DSG lines, source lines, etc., when performing memory operations (e.g., read, program, or erase). In one example, HV circuit 406 may include word line driving circuits (e.g., in row decoder/word line driver 308) that are coupled to word lines and apply a program voltage (Vprog) or a pass voltage (Vpass) in the range of, for example, 5 V and 30 V, to the word lines during program operations. In another example, HV circuit 406 may include bit line driving circuits (e.g., in column decoder/bit line driver 306) that are coupled to bit lines and apply an erase voltage (Veras) in the range of, for example, 5 V and 30 V, to bit lines during erase operations. In some implementations, LV circuits 404 include page buffer circuits (e.g., in latches of page buffer 304) and are configured to buffer the data read from or programmed to the memory cell array. For example, the page buffer may be provided with a voltage of, for example, 3.3 V, by LV voltage source 403. LV circuits 404 can also include logic circuits (e.g., in control logic 312). In some implementations, LLV circuits 402 include an I/O circuit (e.g., in interface 316 and/or data bus 318) configured to interface the memory cell array with a memory controller. For example, the I/O circuit may be provided with a voltage of, for example, 1.2 V, by LLV voltage source 401.

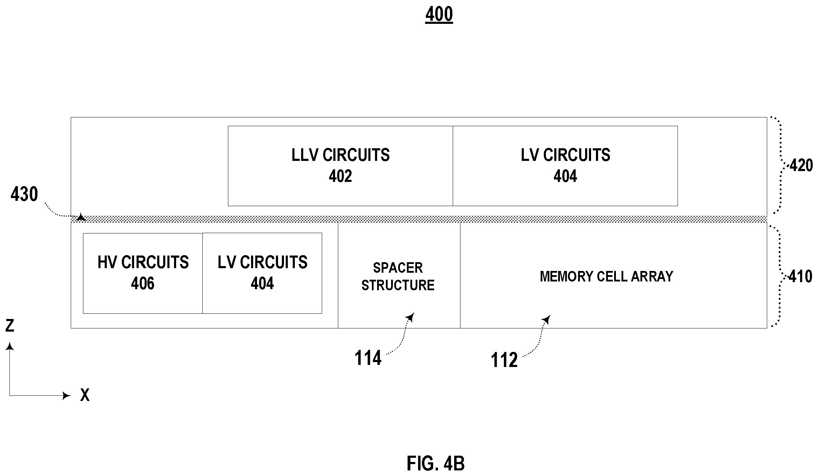

As described above, to reduce the total area occupied by the memory periphery circuits, periphery circuits 202 can be separately formed in different planes based on different performance requirements, such as the applied voltages. For example, FIG. 4B illustrates a schematic diagram of periphery circuits provided with various voltages arranged in separate semiconductor structures, according to some aspects of the present disclosure. In some implementations, HV circuits 406 and LLV circuits 402 are separated, for example, in a first semiconductor structure 410 and a second semiconductor structure 420, respectively, due to their significant difference in voltages and the resulting difference in device dimensions, such as different semiconductor layer (e.g., substrate or thinned substrate) thicknesses and different gate dielectric thicknesses. In one example, the thickness of the semiconductor layer (e.g., a substrate or a thinned substrate) in which HV circuits 406 are formed in first semiconductor structure 410 may be larger than the thickness of the semiconductor layer (e.g., a substrate or a thinned substrate) in which LLV circuits 402 are formed in second semiconductor structure 420. In another example, the thickness of the gate dielectric of transistors forming HV circuits 406 may be larger than the thickness of the gate dielectric of transistors forming LLV circuits 402. For example, the thickness difference may be at least 5-fold. It is understood that stacked LLV circuits 402 and HV circuits 406 in different planes may be formed in two semiconductor structure 410 or 420 separated by a bonding interface 430.

LV circuits 404 can be formed in either first semiconductor structure 410 or second semiconductor structure 420, i.e., in the same plane as LLV circuits 402 or HV circuits 406. As shown in FIG. 4B, in some implementations, some of LV circuits 404 are formed in first semiconductor structure 410, i.e., in the same plane as LLV circuits 402, while some of LV circuits 404 are formed in second semiconductor structure 420, i.e., in the same plane as HV circuits 406. That is, LV circuits 404 can be separated into different planes as well. For example, as shown in FIG. 1, first periphery circuit 116 can include HV circuits 406 and some of LV circuits 404, and second periphery circuit 126 can include LLV circuits 402 and some of LV circuits 404.

In some implementations, the same voltage is applied to both LV circuits 404 in first semiconductor structure 410 and the LV circuits 404 in second semiconductor structure 420, such that the voltage applied to HV circuits 406 in first semiconductor structure 410 is higher than the voltage applied to LV circuits 404 in second semiconductor structure 420, which is in turn higher than the voltage applied to LLV circuits 402 in second semiconductor structure 420. Moreover, since the voltage applied to LV circuits 404 is between the voltages applied to HV circuits 406 and LLV circuits 402, the thickness of the gate dielectric of transistors forming LV circuits 404 is between the thickness of the gate dielectric of transistors forming HV circuits 406 and the thickness of the gate dielectric of transistors forming LLV circuits 402, according to some implementations. For example, the gate dielectric thickness of transistors forming LV circuits 404 may be larger than the gate dielectric thickness of transistors forming LLV circuits 402, but smaller than the gate dielectric thickness of transistors forming HV circuits 406.

Based on the different performance requirements (e.g., associated with different applied voltages), periphery circuits 202 can be separated into at least two stacked semiconductor structures 408 and 410 in different planes. For example, the I/O circuits in interface 316 and/or data bus 318 (as LLV circuits 402) and logic circuits in control logic 312 (as part of LV circuits) are disposed in semiconductor structure 408, while the page buffer circuits in page buffer 304 and driving circuits in row decoder/word line driver 308 and column decoder/bit line driver 306 are disposed in semiconductor structure 410.

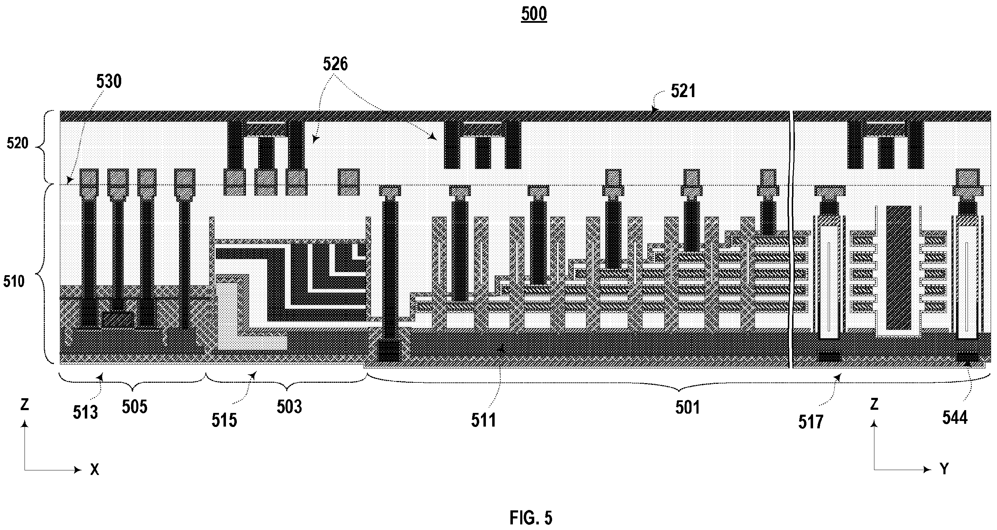

FIG. 5 illustrates a side view of a cross-section of an exemplary 3D memory device 500, according to some aspects of the present disclosure. In some implementations, 3D memory device 500 is a bonded chip including a first semiconductor structure 510 and a second semiconductor structure 520 stacked over first semiconductor structure 510. First and second semiconductor structures 510 and 520 are jointed at a bonding interface 530 therebetween, according to some implementations. In lateral plan, 3D memory device 500 can include core region 501, spacer region 503, and periphery region 505. It is noted that X, Y, and Z axes are included in FIG. 5 to further illustrate the spatial relationship of the components in 3D memory device 500.

As shown in FIG. 5, first semiconductor structure 510 can include semiconductor layer 511, which can include silicon (e.g., single crystalline silicon, c-Si), silicon germanium (SiGe), gallium arsenide (GaAs), germanium (Ge), silicon-on-insulator (SOI), or any other suitable materials. First semiconductor structure 510 of 3D memory device 500 can include first periphery circuit 513 on semiconductor layer 511 in periphery region 505. In some implementations, first periphery circuit 513 can include HV circuits 406 discussed above, and can include HV transistors located on semiconductor layer 511. In some other implementations, first periphery circuit 513 can further include LV circuits 404 discussed above, and can include LV transistors located on semiconductor layer 511. Isolation regions (e.g., STIs) and doped regions (e.g., source regions and drain regions of the transistors) can be formed in semiconductor layer 511.

In some implementations, first semiconductor structure 510 of 3D memory device 100 further includes a memory stack 517 in core region 501. The structure of memory stack 517 will be described in detail below. In some implementations, first semiconductor structure 110 of 3D memory device 100 further includes a spacer structure 515 in spacer region 503 to separate first periphery circuit 513 and memory stack 517. In some implementations, spacer structure 515 includes a turning structure of a dielectric stack which includes a plurality of interleaved dielectric layers that extend in a lateral plane in one portion of the turning structure and extend in a non-lateral plane in another portion of the turning structure. As shown in FIG. 5, portions of turning structure of spacer structure 515 extend vertically. As some other examples not shown, portions of turning structure of spacer structure 515 can have a slop and/or a curve.

As shown in FIG. 5, first semiconductor structure 510 of 3D memory device 500 can further include a bonding layer at bonding interface 530 and above the interconnect layer. Bonding layer can include a plurality of bonding contacts and dielectrics electrically isolating bonding contacts. Bonding contacts can include conductive materials including, but not limited to, W, Co, Cu, Al, silicides, or any combination thereof. The remaining area of bonding layer can be formed with dielectrics including, but not limited to, silicon oxide, silicon nitride, silicon oxynitride, low-k dielectrics, or any combination thereof. The bonding contacts and surrounding dielectrics in bonding layer can be used for hybrid bonding.

As shown in FIG. 5, second semiconductor structure 520 of 3D memory device 100 can include substrate 521, which can include silicon (e.g., single crystalline silicon, c-Si), silicon germanium (SiGe), gallium arsenide (GaAs), germanium (Ge), silicon-on-insulator (SOI), or any other suitable materials. Second semiconductor structure 520 of 3D memory device 500 can include second periphery circuit 526 on substrate 521. In some implementations, second periphery circuit 513 can include LLV circuits 402 discussed above, and can include LLV transistors located on substrate 521. In some other implementations, second periphery circuit 526 can further include LV circuits 404 discussed above, and can include LV transistors located on substrate 521. Although not shown in FIG. 5, isolation regions (e.g., STIs) and doped regions (e.g., source regions and drain regions of the transistors) can be formed in substrate 521.

Similar to for semiconductor structure 510, second semiconductor structure 520 of 3D memory device 500 can also include a bonding layer at bonding interface 530. Bonding layer can include a plurality of bonding contacts and dielectrics electrically isolating bonding contacts. Bonding contacts can include conductive materials including, but not limited to, W, Co, Cu, Al, silicides, or any combination thereof. The remaining area of bonding layer can be formed with dielectrics including, but not limited to, silicon oxide, silicon nitride, silicon oxynitride, low-k dielectrics, or any combination thereof. Bonding contacts and surrounding dielectrics in bonding layer can be used for hybrid bonding. Bonding contacts are in contact with bonding contacts at bonding interface 530, according to some implementations.

As shown in FIG.5, second semiconductor structure 520 can be bonded on top of first semiconductor structure 510 in a face-to-face manner at bonding interface 530. In some implementations, bonding interface 530 is a result of hybrid bonding (also known as "metal/dielectric hybrid bonding"), which is a direct bonding technology (e.g., forming bonding between surfaces without using intermediate layers, such as solder or adhesives) and can obtain metal-metal bonding and dielectric-dielectric bonding simultaneously. In some implementations, bonding interface 530 is the place at which first semiconductor structure 510 and second semiconductor structure 520 are met and bonded.

In some implementations, 3D memory device 500 is a NAND Flash memory device in which memory cells are provided in the form of an array of NAND memory strings. Each NAND memory string can include a respective channel structure. As shown in FIG. 5, each channel structure can extend vertically through a plurality of pairs each including a stack conductive layer and a stack dielectric layer. The interleaved stack conductive layers and stack dielectric layers are part of memory stack 517. The number of the pairs of stack conductive layers and stack dielectric layers in memory stack 517 determines the number of memory cells in 3D memory device 500. It is understood that, memory stack 517 has a staircase structure, which includes a plurality of memory decks stacked over one another. The numbers of the pairs of stack conductive layers and stack dielectric layers in each memory deck can be the same or different.

Memory stack 517 can include a plurality of interleaved stack conductive layers and stack dielectric layers. Stack conductive layers and stack dielectric layers in memory stack 517 can alternate in the vertical direction. In other words, except the ones at the top or bottom of memory stack 517, each stack conductive layer can be adjoined by two stack dielectric layers on both sides, and each stack dielectric layer can be adjoined by two stack conductive layers on both sides. Stack conductive layers can include conductive materials including, but not limited to, W, Co, Cu, Al, polycrystalline silicon (polysilicon), doped silicon, silicides, or any combination thereof. Each stack conductive layer can include a gate electrode (gate line) surrounded by an adhesive layer and a gate dielectric layer. The gate electrode of stack conductive layer can extend laterally as a word line, ending at one or more staircase structures of memory stack 517. Stack dielectric layers can include dielectric materials including, but not limited to, silicon oxide, silicon nitride, silicon oxynitride, or any combination thereof.

In some implementations, each channel structure can have a cylinder shape (e.g., a pillar shape), and can extend vertically through interleaved stack conductive layers and stack dielectric layers of memory stack 517 and in contact with semiconductor layer 511. Each channel structure includes a channel hole filled with a composite functional layer, a semiconductor channel, and a capping structure that are arranged radially from the center toward the outer surface of the pillar in this order, according to some implementations. The capping structure can include dielectric materials, such as silicon oxide, and/or an air gap. The composite functional layer can radially circumscribe the semiconductor channel along the lateral direction. A composite functional layer can be formed laterally between the semiconductor channel and memory stack517. In some implementations, the semiconductor channel includes silicon, such as amorphous silicon, polysilicon, or single crystalline silicon. In some implementations, the semiconductor channel can include a doped portion and an undoped portion. As described below with respect to the fabrication process, from the fabrication process perspective, in some implementations, the doped portion of the semiconductor channel extends beyond memory stack 517 and into semiconductor layer 511.

In some implementations, first semiconductor structure 510 of 3D memory device 500 further includes an interconnect layer (not shown) above first periphery circuits 513 and memory stack 517 to transfer electrical signals to periphery circuits. The interconnect layer can include a plurality of interconnects (also referred to herein as contacts), including lateral interconnect lines and vertical interconnect access (VIA) contacts. As used herein, the term interconnects can broadly include any suitable types of interconnects, such as middle-end-of-line (MEOL) interconnects and back-end-of-line (BEOL) interconnects. The interconnect layer can further include one or more interlayer dielectric (ILD) layers (a.k.a. intermetal dielectric (IMD) layers) in which the interconnect lines and VIA contacts can form. That is, the interconnect layer can include interconnect lines and VIA contacts in multiple ILD layers. The interconnect lines and VIA contacts in the interconnect layer can include conductive materials including, but not limited to, tungsten (W), cobalt (Co), copper (Cu), aluminum (Al), silicides, or any combination thereof. The ILD layers in the interconnect layer can include dielectric materials including, but not limited to, silicon oxide, silicon nitride, silicon oxynitride, low dielectric constant (low-k) dielectrics, or any combination thereof.

Instead of the front side contacts/pads, 3D memory device 500 can include one or more backside contacts/pads 544 above and in contact with doped semiconductor layer 511, as shown in FIG. 5. Contacts/pads 544 and memory stack 517 can be disposed at opposite sides of doped semiconductor layer 511 and thus, viewed as a "backside" contacts/pads. In some implementations, contacts/pads 544 can be formed by any suitable BEOL method and electrically connected to the semiconductor channel of channel structures through doped semiconductor layer 511. Contacts/pads 544 can include any suitable types of contacts and/or pads. In some implementations, contacts/pads 544 can include a VIA contact, a wall-shaped contact extending laterally, one or more conductive layers, such as a metal layer (e.g., W, Co, Cu, or Al) or a silicide layer surrounded by an adhesive layer (e.g., titanium nitride (TiN)), etc. In some implementations, one or more contacts/pads 544 may further includes a spacer (e.g., a dielectric layer) to electrically separate the one or more contacts/pads 544 from doped semiconductor layer 511.

In some implementations, 3D memory device 500 further includes periphery contacts each extending vertically in periphery region 505. In some implementations, the periphery contact can be in contact with transistors of first periphery circuit 513. Periphery contacts each can include one or more conductive layers, such as a metal layer (e.g., W, Co, Cu, or Al) or a silicide layer surrounded by an adhesive layer (e.g., TiN). In some implementations, 3D memory device 500 further includes a variety of local contacts (also known as "C1"), which are in contact with a structure in memory stack 517 directly. In some implementations, the local contacts include channel local contacts each below and in contact with the lower end of respective channel structure. Each channel local contact can be electrically connected to a bit line contact (not shown) for bit line fan-out. In some implementations, the local contacts further include word line local contacts each below and in contact with respective stack conductive layer (including a word line) at the staircase structure of memory stack 517 for word line fan-out. Local contacts, such as channel local contacts and word line local contacts, can be electrically connected to first periphery circuit 513 and/or second periphery circuit 526 through interconnect structures. Local contacts, such as channel local contacts and word line local contacts, each can include one or more conductive layers, such as a metal layer (e.g., W, Co, Cu, or Al) or a silicide layer surrounded by an adhesive layer (e.g., TiN).

Although an exemplary 3D memory device 500 is shown in FIG. 5, it is understood that by varying the relative positions of first and second semiconductor structures 510 and 520, the usage of various interconnects, contacts, and/or the pad-out locations (e.g., through first semiconductor structure 510 and/or second semiconductor structure 520), any other suitable architectures of 3D memory devices may be applicable in the present disclosure without further detailed elaboration.

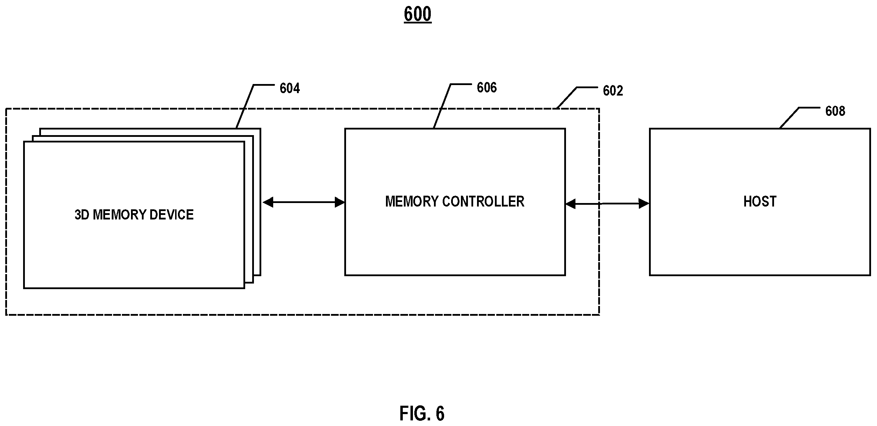

FIG. 6 illustrates a block diagram of an exemplary system 600 having a 3D memory device, according to some aspects of the present disclosure. System 600 can be a mobile phone, a desktop computer, a laptop computer, a tablet, a vehicle computer, a gaming console, a printer, a positioning device, a wearable electronic device, a smart sensor, a virtual reality (VR) device, an argument reality (AR) device, or any other suitable electronic devices having storage therein. As shown in FIG. 6, system 600 can include a host 608 and a memory system 602 having one or more 3D memory devices 604 and a memory controller 606. Host 608 can be a processor of an electronic device, such as a central processing unit (CPU), or a system-on-chip (SoC), such as an application processor (AP). Host 608 can be configured to send or receive data to or from 3D memory devices 604.

3D memory device 604 can be any 3D memory devices disclosed herein, such as 3D memory devices 100 and 400 shown in FIGs. 1 and 4B. In some implementations, each 3D memory device 604 includes a NAND Flash memory. Consistent with the scope of the present disclosure, the semiconductor channel of 3D memory device 604 can be partially doped such that part of the semiconductor channel that forms the source contact is highly doped to lower the potential barrier while leaving another part of the semiconductor channel that forms the memory cells remaining undoped or lowly doped. One end of each channel structure of 3D memory device 604 can be opened from the backside to expose the doped part of the respective semiconductor channel. 3D memory device 604 can further include a doped semiconductor layer electrically connecting the exposed doped parts of the semiconductor channels to further reduce the contact resistance and sheet resistance. Moreover, 3D memory device 604 can include a composite dielectric film having a gate dielectric portion that faces the source select gate line(s). The gate dielectric portion can be free of silicon nitride (e.g., including only silicon oxide) and act as the gate dielectric of the SSG transistor. As a result, the electric performance of 3D memory device 604 can be improved, which in turn improves the performance of memory system 602 and system 600, e.g., achieving higher operation speed.

Memory controller 606 (a.k.a.. a controller circuit) is coupled to 3D memory device 604 and host 608 and is configured to control 3D memory device 604, according to some implementations. Memory controller 606 can manage the data stored in 3D memory device 604 and communicate with host 608. In some implementations, memory controller 606 is designed for operating in a low duty-cycle environment like secure digital (SD) cards, compact Flash (CF) cards, universal serial bus (USB) Flash drives, or other media for use in electronic devices, such as personal computers, digital cameras, mobile phones, etc. In some implementations, memory controller 606 is designed for operating in a high duty-cycle environment SSDs or embedded multi-media-cards (eMMCs) used as data storage for mobile devices, such as smartphones, tablets, laptop computers, etc., and enterprise storage arrays. Memory controller 606 can be configured to control operations of 3D memory device 604, such as read, erase, and program operations. Memory controller 606 can also be configured to manage various functions with respect to the data stored or to be stored in 3D memory device 604 including, but not limited to bad-block management, garbage collection, logical-to-physical address conversion, wear leveling, etc. In some implementations, memory controller 606 is further configured to process error correction codes (ECCs) with respect to the data read from or written to 3D memory device 604. Any other suitable functions may be performed by memory controller 606 as well, for example, formatting 3D memory device 604. Memory controller 606 can communicate with an external device (e.g., host 608) according to a particular communication protocol. For example, memory controller 606 may communicate with the external device through at least one of various interface protocols, such as a USB protocol, an MMC protocol, a periphery component interconnection (PCI) protocol, a PCI-express (PCI-E) protocol, an advanced technology attachment (ATA) protocol, a serial-ATA protocol, a parallel-ATA protocol, a small computer small interface (SCSI) protocol, an enhanced small disk interface (ESDI) protocol, an integrated drive electronics (IDE) protocol, a Firewire protocol, etc.

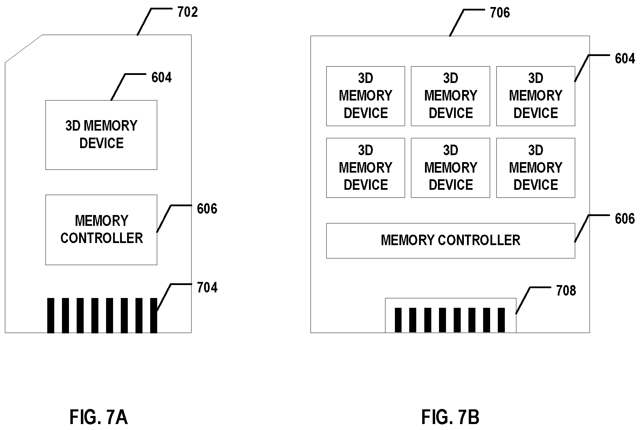

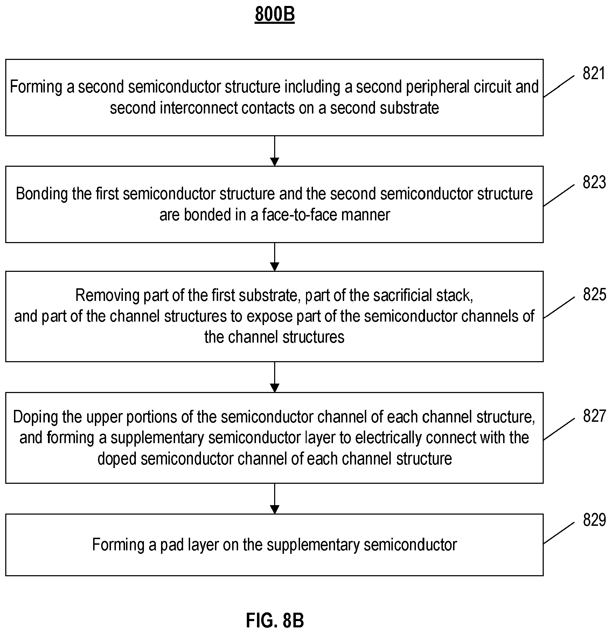

Memory controller 606 and one or more 3D memory devices 604 can be integrated into various types of storage devices, for example, be included in the same package, such as a universal Flash storage (UFS) package or an eMMC package. That is, memory system 602 can be implemented and packaged into different types of end electronic products. In one example as shown in FIG. 7A, memory controller 606 and a single 3D memory device 604 may be integrated into a memory card 702. Memory card 702 can include a PC card (PCMCIA, personal computer memory card international association), a CF card, a smart media (SM) card, a memory stick, a multimedia card (MMC, RS-MMC, MMCmicro), an SD card (SD, miniSD, microSD, SDHC), a UFS, etc. Memory card 702 can further include a memory card connector 704 electrically coupling memory card 702 with a host (e.g., host 608 in FIG. 7). In another example as shown in FIG. 8B, memory controller 606 and multiple 3D memory devices 604 may be integrated into an SSD 706. SSD 706 can further include an SSD connector 708 electrically coupling SSD 706 with a host (e.g., host 608 in FIG. 7). In some implementations, the storage capacity and/or the operation speed of SSD 706 is greater than those of memory card 702.

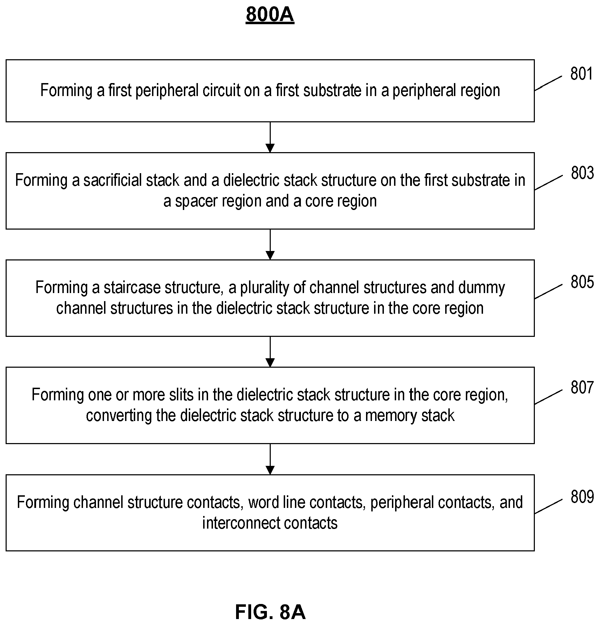

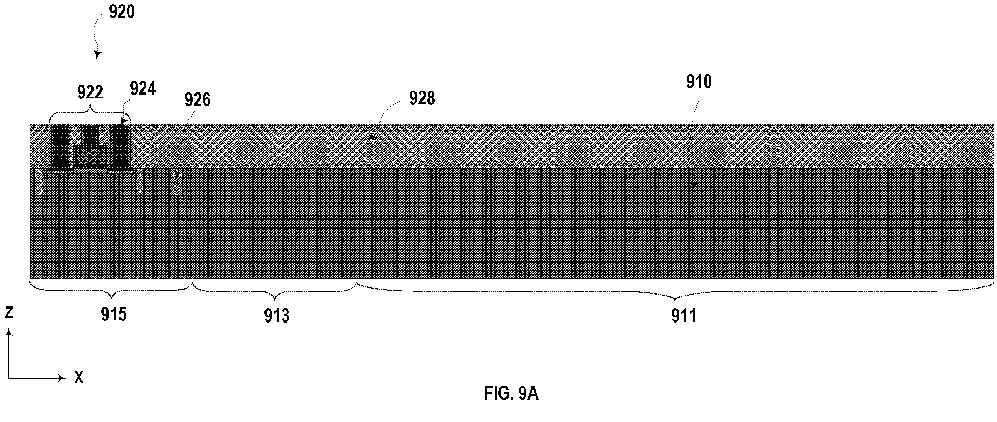

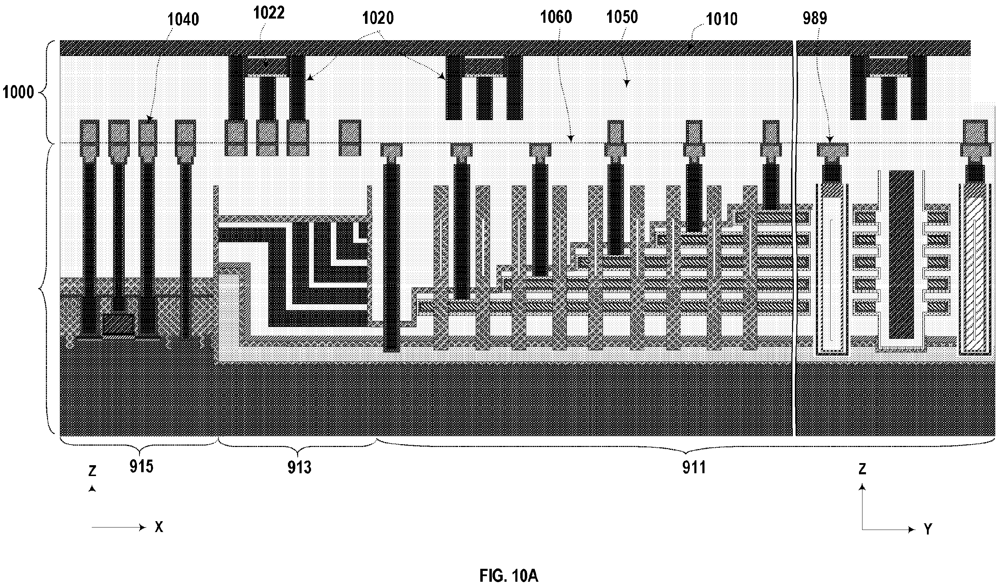

Referring to FIGs. 8A-8B, flow diagrams of an exemplary method for forming a 3D memory device are illustrated in accordance with some implementations of the present disclosure. It should be understood that the operations shown in FIGs. 8A-8B are not exhaustive and that other operations can be performed as well before, after, or between any of the illustrated operations. Further, some of the operations may be performed simultaneously, or in a different order than shown in FIGs. 8A-8B. FIGs. 9A-9J and 10A-10I illustrate schematic cross-sectional views of an exemplary 3D memory device at certain fabricating stages of the method shown in FIGs. 8A-8B according to some implementations of the present disclosure.

Referring to FIG. 8A, method 800A can start at operation 801, in which a first periphery circuit can be formed on a first substrate in a periphery region.

In some implementations, first substrate 910 (also referred as an "initial semiconductor layer") can be any suitable semiconductor substrate having any suitable structure, such as a monocrystalline single-layer substrate, a polycrystalline silicon (polysilicon) single-layer substrate, a polysilicon and metal multi-layer substrate, etc. In some implementations, as illustrated in FIG. 9A, the formed 3D structure can include a core region 911, a periphery region 915, and a spacer region 913 separating core region 911 and periphery region 915. In some implementations, first periphery circuit 920 can be formed in periphery region 915 using a plurality of processes including, but not limited to, photolithography, etching, thin film deposition, thermal growth, implantation, chemical mechanical polishing (CMP), and any other suitable processes. In some implementations, first periphery circuit 920 includes a plurality of transistors 922 that are separated from each other by shallow trench isolations (STI) 926 formed by wet etching and/or dry etching and thin film deposition. In some implementations, first periphery circuit 920 includes HV circuits 406, and transistors 922 can include HV transistors. In some implementations, first periphery circuit 920 further includes LV circuits 404, transistors 922 can further include LV transistors. In some implementations, doped regions (e.g., wells, sources, and drains of transistors 922) can be formed on or in first substrate 910 by ion implantation and/or thermal diffusion, which function, for example, as source regions and/or drain regions of transistors 922. Corresponding transistor contacts 924 (e.g., gate contact, source contact, and drain contact) can be formed in an insulating layer 928 covering first substrate 910.

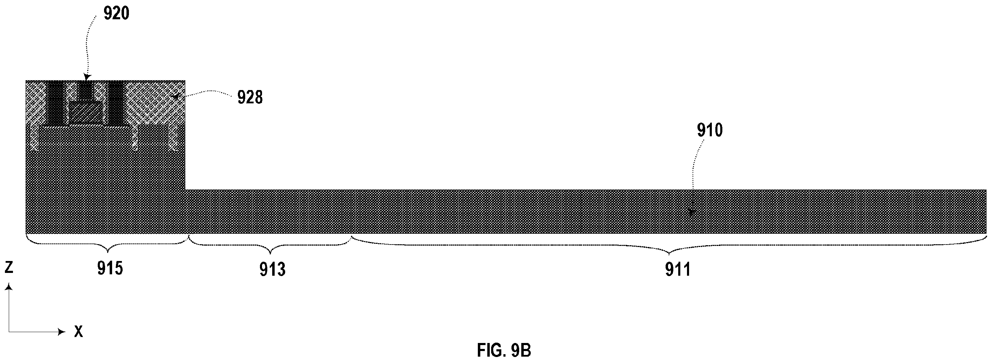

In some implementations, insulating layer 928 can include any suitable insulating material and/or dielectric material, such as silicon oxide, etc. In some implementations as shown in FIG. 9A, insulating layer 928 can be an oxide layer deposited on entire first substrate 910 and covering first periphery circuit 920. As shown in FIG. 9B, portions of the insulating layer 928 in spacer region 913 and core region 911 can be removed by any suitable process. In some implementations, upper portions of first substrate 910 in spacer region 913 and core region 911 can be removed by any suitable process. As such, a protruding structure can be formed in periphery region 915, and a recess can be formed in spacer region 913 and core region 911 as shown in FIG. 9B. It is noted that, the sidewall of the protruding structure at the boundary of periphery region 915 and spacer region 913 is vertical in some implementations as shown in FIG. 9B. However, in some other implementations not shown, the sidewall of the protruding structure at the boundary of periphery region 915 and spacer region 913 can have a slope.

Referring back to FIG. 8A, method 800A can then proceed to operation 803, in which a sacrificial stack and a dielectric stack structure can be formed on the first substrate in a spacer region and a core region. The sacrificial stack and the dielectric stack structure can extend horizontally in the core region and include a turning structure in the spacer region.

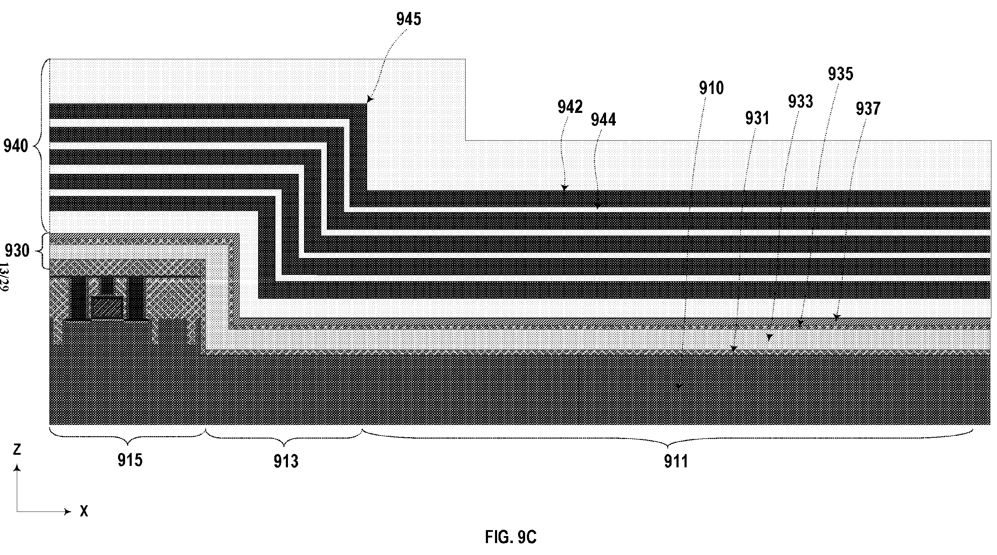

As illustrated in FIG. 9C, sacrificial stack 930 including first stop layer 931, sacrificial semiconductor layer 933, second stop layer 935, and barrier layer 937. First stop layer 931 can be formed above first periphery circuit 920 in periphery region 915, and above first substrate 910 in spacer region 913 and core region 911. First stop layer 931 can act as a CMP/etch stop layer when removing portions of first substrate 910 from the backside and thus, may include any suitable materials other than the material of first substrate 910, such as silicon nitride or silicon oxide. Sacrificial semiconductor layer 933 can be formed to cover first stop layer 931. In some implementations, portions of sacrificial semiconductor layer 933 can include polysilicon, and can be removed in subsequent processes. Second stop layer 935 is formed to cover sacrificial semiconductor layer 933. Second stop layer 935 can act as an etch stop layer when removing portions of sacrificial semiconductor layer 933 from the backside and thus, may include any suitable materials other than the material of sacrificial semiconductor layer 933, such as silicon nitride or silicon oxide. Barrier layer 937 is formed on second stop layer 935. Barrier layer 937 can include polysilicon, a high-k dielectric, or a metal, and can be used for blocking ions implanting in subsequent ion implantation processes.

In some implementations, sacrificial stack 930 including first stop layer 931, sacrificial semiconductor layer 933, second stop layer 935, and barrier layer 937 can be sequentially formed above first periphery circuit 920 and first substrate 910 by using one or more thin film deposition processes including, but not limited to, Chemical Vapor Deposition (CVD), Physical Vapor Deposition (PVD), Atomic Layer Deposition (ALD), or any combination thereof. It is understood that in some examples, pad oxide layers (e.g., silicon oxide layers, not shown) may be formed between first stop layer 931, sacrificial semiconductor layer 933, second stop layer 935, and barrier layer 937 to relax the stress between different layers and avoid peeling.

As illustrated in FIG. 9C, in some implementations, dielectric stack structure 940 including interleaved stack dielectric layers and stack sacrificial layers can be formed to cover sacrificial stack 930. Dielectric stack structure 940 can include a plurality pairs of a first dielectric layer 942 (referred to herein as "stack sacrificial layer" 942) and a second dielectric layer 944 (referred to herein as "stack dielectric layer" 944, together referred to herein as "dielectric layer pairs"). Stack dielectric layers 944 and stack sacrificial layers 942 can be alternatingly deposited on sacrificial stack 930 to form dielectric stack structure 940. In some implementations, each stack dielectric layer 944 includes a layer of silicon oxide, and each stack sacrificial layer 942 includes a layer of silicon nitride. Dielectric stack structure 940 can be formed by one or more thin film deposition processes including, but not limited to, CVD, PVD, ALD, or any combination thereof.

As illustrated in FIG. 9C, the portions of sacrificial stack 930 and dielectric stack structure 940 extend horizontally in core region 911 and in periphery region 915. Since the portions of sacrificial stack 930 and dielectric stack structure 940 in periphery region 915 cover first periphery circuit 920, the portions of sacrificial stack 930 and dielectric stack structure 940 in periphery region 915 are higher than the portions of sacrificial stack 930 and dielectric stack structure 940 in core region 911, and are connected by a turning structure 945 in spacer region 913. Portions of turning structure 945 in spacer region 913 extend in a direction not parallel to the horizontal plane (e.g., bottom surface of first substrate 910). Portions of turning structure 945 in spacer region 913 extend vertically as shown in FIG. 9C. As some other examples are not shown, portions of turning structure 945 in spacer region 913 can have a slop and/or a curve.

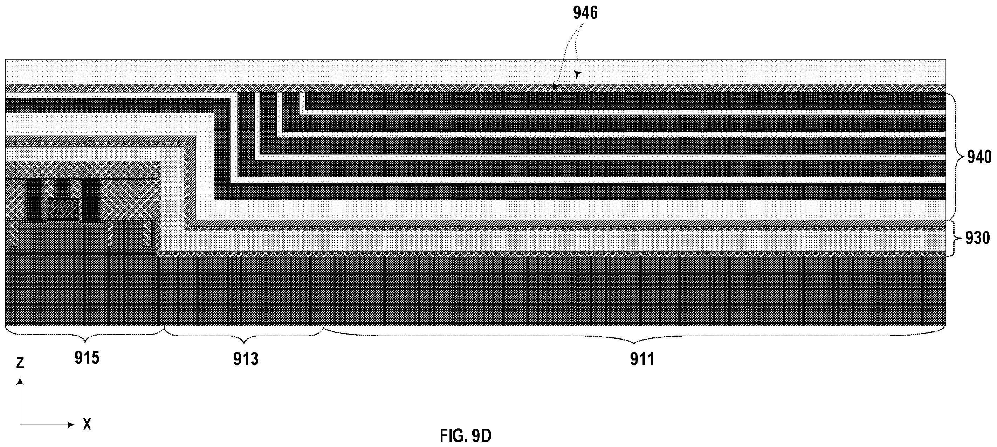

As illustrated in FIG. 9D, portions of dielectric stack structure 940 in periphery region 915 can be removed, such that the top surface of dielectric stack structure 940 in periphery region 915, spacer region 913, and core region 911 can be coplanar. One or more pad oxide layers 946 (e.g., silicon oxide layers) may be formed on the remaining portions of dielectric stack structure 940 to relax the compressive or tensile stress of the formed 3D structure and avoid peeling.

Referring back to FIG. 8A, method 800A can then proceed to operation 805, in which a staircase structure, a plurality of channel structures and dummy channel structures can be formed in the dielectric stack structure in the core region.

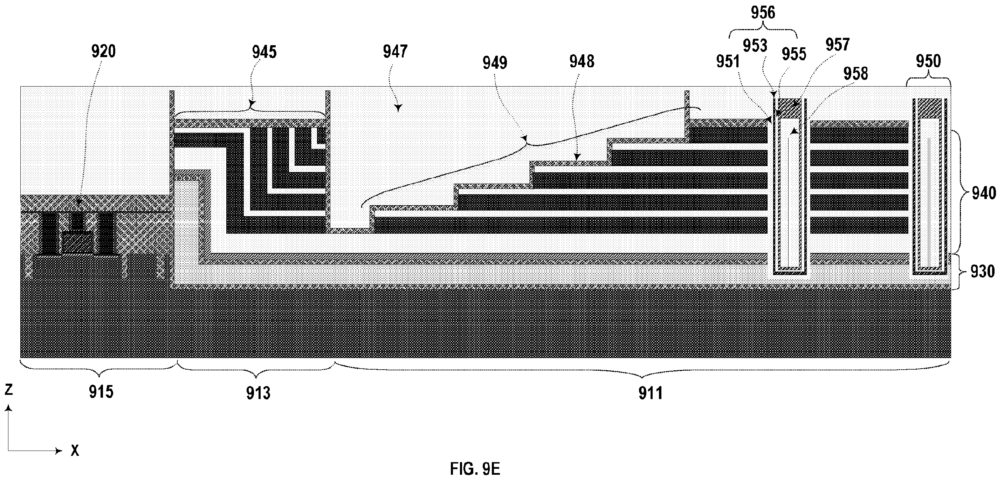

As illustrated in FIG. 9E, staircase structure 949 is in core region 911 adjacent to spacer region 913. The staircase structure can be formed by performing a plurality of so-called "trim-etch" cycles to the dielectric layer pairs of dielectric stack structure 940 toward first substrate 910. Due to the repeated trim-etch cycles applied to the dielectric layer pairs of dielectric stack structure 940, dielectric stack structure 940 can have one or more tilted edges and a top dielectric layer pair shorter than the bottom one, as shown in FIG. 9E.

A staircase insulating layer 948 can be formed to cover the staircase structure 949. In some implementations, a deposition process can be performed to form the staircase insulating layer 948. In some implementations, a filling insulating structure 947 can be formed to cover staircase structure 949, periphery circuit 920, turning structure 945, and dielectric stack structure 940. A CMP process can be performed to planarize the top surface of the filling insulating structure 947.

A plurality of channel structures 950 each extending through and beyond the dielectric stack structure 940 and the filling insulating structure 947 can be formed in core region 911. Each channel structure 950 can include functional layer 956 and semiconductor channel 957. In some implementations, functional layer 956 is a composite dielectric layer including a blocking layer 951, a storage layer 953, and a tunneling layer 955.

To form the channel structure 950, a channel hole extending through dielectric stack structure 940, filling insulating structure 947, and partial sacrificial stack 930 is formed. In some implementations, a plurality of channel holes are formed, such that each channel hole becomes the location for growing an individual channel structure 950 in the subsequent process. In some implementations, fabrication processes for forming the channel holes of channel structures 950 include wet etching and/or dry etching.

As illustrated in FIG. 9E, blocking layer 951, storage layer 953, tunneling layer 955, and semiconductor channel 957 are sequentially formed in this order along sidewalls and the bottom surface of each channel hole. In some implementations, blocking layer 951, storage layer 953, and tunneling layer 955 are first deposited along the sidewalls and bottom surface of the channel hole in this order using one or more thin film deposition processes, such as ALD, CVD, PVD, any other suitable processes, or any combination thereof, to form the memory film. Semiconductor channel 957 then can be formed by depositing a semiconductor material, such as polysilicon (e.g., undoped polysilicon), over third dielectric layer 955 using one or more thin film deposition processes, such as ALD, CVD, PVD, any other suitable processes, or any combination thereof. In some implementations, a first silicon oxide layer, a silicon nitride layer, a second silicon oxide layer, and a polysilicon layer (an "ONOS" structure) are sequentially deposited to form blocking layer 951, storage layer 953, tunneling layer 955, and semiconductor channel 957.

In some implementations, a capping structure 958 is formed in the channel hole to fully or partially fill the channel hole (e.g., without or with an air gap). The capping structure 958 can be formed by depositing a dielectric material, such as silicon oxide, using one or more thin film deposition processes, such as ALD, CVD, PVD, any other suitable processes, or any combination thereof. In some implementations, a channel plug (not shown) can then be formed in the top portion of the channel hole for connecting semiconductor channel 957 of each channel structure 950.

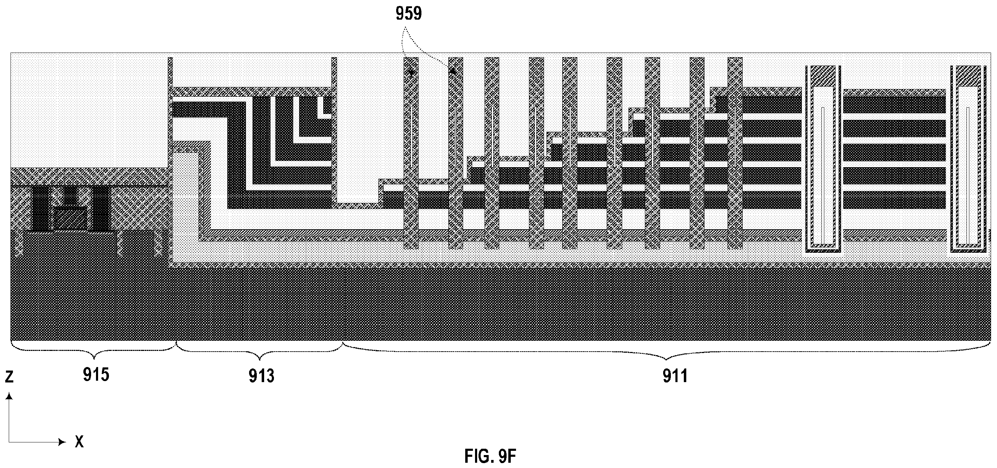

As illustrated in FIG. 9F, a plurality of dummy channel structures 959 can be formed in core region 911 and extending through and beyond filling insulating structure 947, staircase structure 949, and filling insulating structure 947. In some implementations, a plurality of dummy channel holes are formed in any suitable positions in core region 911, such that each dummy channel hole becomes the location for growing an individual dummy channel structure 959 in the subsequent process. In some implementations, fabrication processes for forming the dummy channel holes of dummy channel structures 959 include wet etching and/or dry etching. A deposition process can then be performed to fill the multiple dummy channel holes with any suitable dielectric material, such as SiO₂. As such, multiple dummy channel structures 959 can be formed to provide mechanical support for the 3D memory array structures.

Referring back to FIG. 8A, method 800A can then proceed to operation 807, in which one or more slits can be formed in the dielectric stack structure in the core region and extending along a word line direction, the dielectric stack structure can be converted to a memory stack. That is, the stack sacrificial layers in the dielectric stack structure can be replaced by multiple gate structures. In some implementations, one or more array common source (ACS) contacts can be formed in each slit.

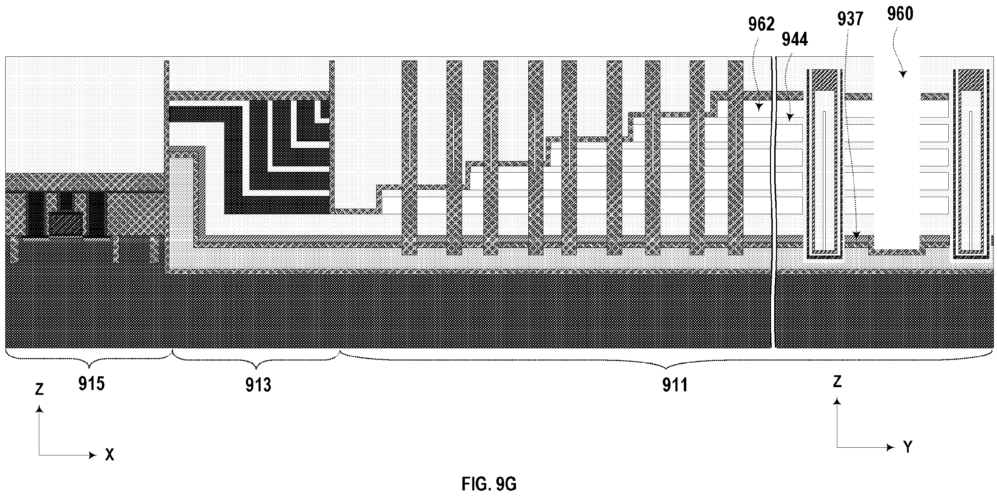

As shown in the cross-sectional view of core region 911 in Y-Z plane in FIG. 9G, in some implementations, each slit 960 can vertically penetrate through dielectric stack structure 940 and barrier layer 937, and extend vertically into sacrificial stack 930, and can extend laterally in a straight line along a word line direction (i.e., X direction) between two arrays of channel structures 950. The one or more slits 960 can be formed by forming a mask layer (not shown) over dielectric stack structure 940 and patterning the mask using, e.g., photolithography, to form openings corresponding to the multiple slits in the patterned mask layer. A suitable etching process, e.g., dry etch and/or wet etch, can be performed to remove portions of dielectric stack structure 940 exposed by the openings until the one or more slits expose sacrificial semiconductor layer 933. The mask layer can be removed after the formation of the multiple slits. An insulating layer, such as an oxide layer, can be formed at a bottom of each slit 960.

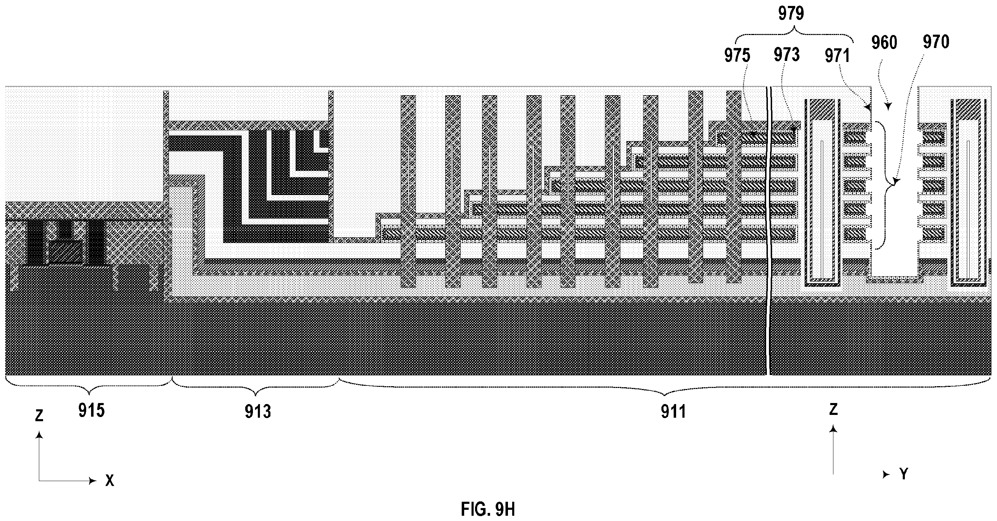

A gate replacement then can be performed through the one or more slits 960 to replace stack sacrificial layers 942 in dielectric stack structure 940 by multiple gate structures 979. After the gate replacement, dielectric stack structure 940 can become a memory stack 970, as shown in FIG. 9H.

As illustrated in FIG. 9G, stack sacrificial layers 942 in dielectric stack structure 940 can be removed by applying etchants through the one or more slits 960. Any suitable etching process, e.g., an isotropic dry etch or a wet etch, can be used to remove stack sacrificial layers 942. The etching process can have sufficiently high etching selectivity of the material of stack sacrificial layers 942 over the materials of the stack dielectric layers 944, such that the etching process can have minimal impact on the stack dielectric layers 944. The isotropic dry etch and/or the wet etch can remove stack sacrificial layers 942 in various directions to expose the top and bottom surfaces of each stack dielectric layer 944. As such, multiple horizontal trenches 962 can then be formed interleaved between stack dielectric layers 944. Each horizontal trench 962 can extend in a horizontal direction, and can be used as a space for a gate structure 979 to be formed in the subsequent processes. It is noted that, the term "horizontal/horizontally" used herein means nominally parallel to a lateral surface of first substrate 910.

In some implementations, stack sacrificial layers 942 include silicon nitride, and the etchant of the isotropic dry etch includes one or more of CF₄, CHF₃, C4F₈, C4F₆, and CH₂F₂. The radio frequency (RF) power of the isotropic dry etch can be lower than about 100 W, and the bias can be lower than about 10 V. In some implementations, stack sacrificial layers 942 include silicon nitride, and the etchant of the wet etch includes phosphoric acid. After stack sacrificial layers 942 are removed, the multiple slits 960 and multiple horizontal trenches can be cleaned by using any suitable cleaning process. For example, a phosphoric acid rinsing process can be performed to remove the impurities on the inner wall of the horizontal trenches. In some implementations, a rinsing temperature can be in a range from about 100 °C to about 200 °C, and a rinsing time can be in a range from about 10 minutes to about 100 minutes.

In some implementations, stack gate structures 979 can be formed in horizontal trenches 962, as shown in FIG. 9H. In some implementations, each stack gate structure 979 can include a gate electrode 975 (also referred to as stack conductive layer 975) wrapped by insulating films 971 and 973. The insulating films 971 and 973 can be used as one or more gate dielectric layers 971 for insulating the respective word line (i.e., gate electrode 975).

In some implementations, insulating film 971 and 973 can be formed to cover the exposed surfaces of the horizontal trenches with one or more suitable insulating materials. For example, one or more suitable deposition processes, such as CVD, PVD, and/or ALD, can be utilized to deposit the one or more insulating materials into the horizontal trenches. In some implementations, a recess etching process and/or a CMP process can be used to remove excessive insulating material(s). The one or more insulating materials can include any suitable materials that provide an electrical insulating function. In some implementations, gate dielectric layer 971, such as a high-k dielectric layer, is formed along the sidewall and at the bottom of slit 960 as well.

In some implementations, gate electrodes 975 can be formed in horizontal trenches 962 respectively. Gate electrodes 975 can be formed by filling the horizontal trenches 962 with a suitable gate electrode metal material. Gate electrodes 975 can provide the base material for the word lines. The gate electrode metal material can include any suitable conductive material, e.g., tungsten, aluminum, copper, cobalt, or any combination thereof, for forming the word lines. The gate electrode material can be deposited into horizontal trenches using a suitable deposition method such as CVD, PVD, plasma-enhanced CVD (PECVD), sputtering, metal-organic chemical vapor deposition (MOCVD), and/or ALD.

In some implementations, portions of stack gate structures 979 can be removed by a recess etching process. In some implementations, in order to ensure the insulation between multiple gate electrodes 975, a recess etching process, such as a wet etching process, can be performed to remove the exposed portions of the multiple gate structures 979. In doing so, a recess can be formed in each horizontal trench 962 adjacent to the sidewalls of slit 960. Memory stack 970 including interleaved stack gate structures 979 and stack dielectric layers 944 is thereby formed, replacing dielectric stack structure 940 (shown in FIG. 9H), according to some implementations.

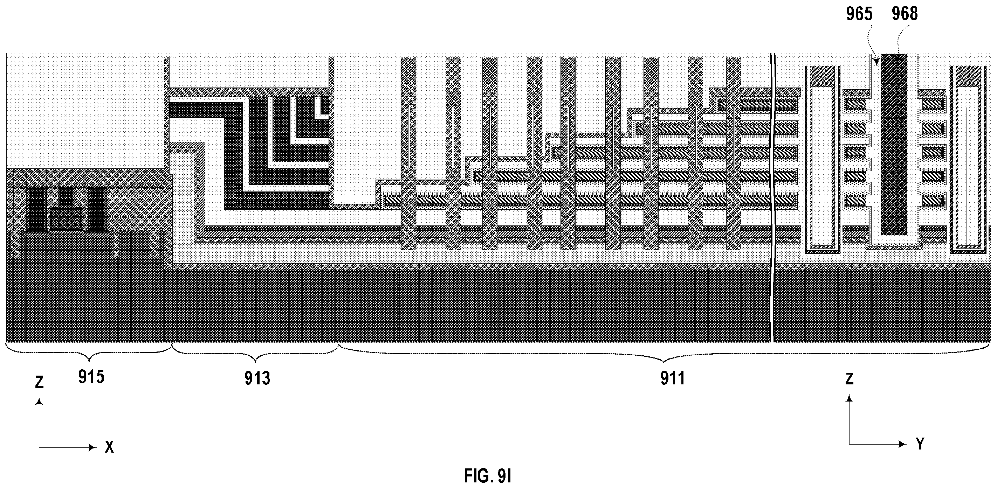

In some implementations, as shown in FIG. 9I, a gate line spacer (GLSP) layer 965 can be formed on both side walls of each slit 960. The GLSP layer 965 can be used to provide electrical insulation between the multiple gate structures 979 and one or more array common source (ACS) contacts 968 formed in subsequent processes. In some implementations, the GLSP layer 965 can be formed by using any suitable deposition process, such as an atomic layer deposition (ALD) process to deposit a low temperature oxide material or a high temperature oxide material to fill the multiple slits 960. In some implementations, as shown in FIG. 9I, one or more ACS contacts 968 can be formed in each slit 960 by performing a deposition process to fill each slit 960 with any suitable conductive material, such as metal materials including tungsten, aluminum, copper, polysilicon, silicides, and/or combinations thereof, etc. A CMP process can be performed to planarize the top surfaces of the one or more ACS contacts 968.

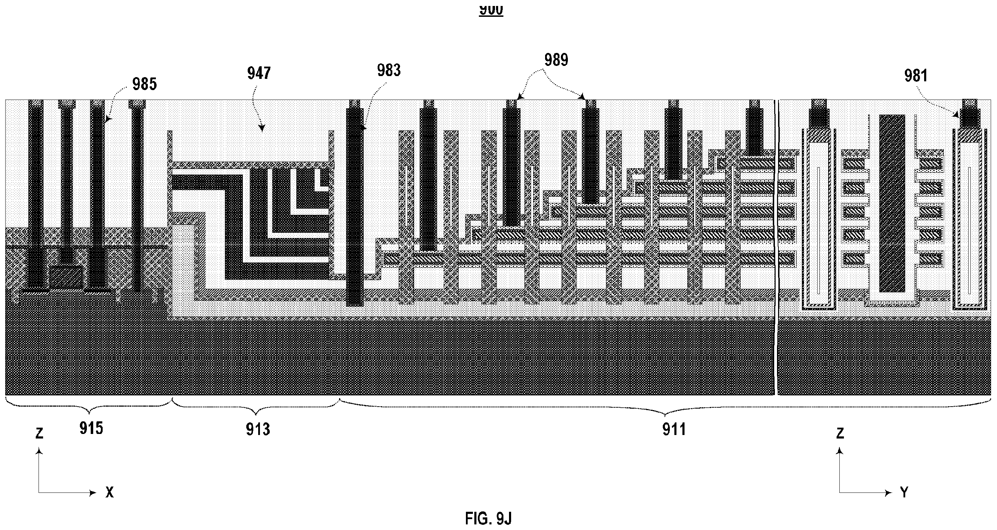

Referring back to FIG. 8A, method 800A can then proceed to operation 809, in which a plurality of channel structure contacts, word line contacts, and periphery contacts and a plurality of interconnect contacts can be formed. As such, the first semiconductor structure 900 is formed, as shown in cross-sectional views in both X-Z plane and Y-Z plane in FIG. 9J.

In some implementations, a plurality of channel structure contacts 981 and word line contacts 983 can be formed in core region 911, and a plurality of periphery contacts 985 can be formed in periphery region 915. In some implementations, an end (e.g., the upper end) of each channel structure contact 981, word line contact 983, and periphery contact 985 can be flush with one another, e.g., on the top surface of the filling insulating structure 947 in which channel structure contacts 981, word line contacts 983, and periphery contacts 985 are formed. Another end (e.g., the lower end) of each channel structure contact 981, word line contact 983, and periphery contact 985 can be in contact with the respective array wafer structure. For example, the lower end of each channel structure contacts 981 can be in contact with corresponding capping structure of semiconductor channel 957 in channel structure 950, the lower end of each word line contacts 983 can be in contact with corresponding gate electrode 975 (word line) in one level of staircase structure 949, and the lower end of each periphery contact 985 can be in contact with corresponding periphery circuit contact (e.g., source contact, drain contact, gate contact, etc.).

It is understood that, a fabricating process for forming the plurality of channel structure contacts 981, word line contacts 983, and periphery contacts 985 can include multiple processes, for example, photolithography, etching, thin film deposition, and CMP. For example, the plurality of channel structure contacts 981, word line contacts 983, and periphery contacts 985 can be formed through the filling insulating structure 947 by first deep etching vertical openings (e.g., by wet etching and/or dry etching), followed by filling the vertical openings with conductor materials using ALD, CVD, PVD, any other suitable processes, or any combination thereof. The conductor materials used for filling the vertical openings can include, but are not limited to, W, Co, Cu, Al, polysilicon, silicides, or any combination thereof. In some implementations, other conductor materials are also used to fill the openings to function as a barrier layer, an adhesion layer, and/or a seed layer.

In some implementations, the plurality of channel structure contacts 981, word line contacts 983, periphery contacts 985, and/or the one or more ACS contacts (not shown), can be simultaneously formed in the same contact forming process. In some implementations, each process in the contact forming process needs to be performed only once for all of the channel structure contacts 981, word line contacts 983. periphery contacts 985, and/or one or more ACS contacts. For example, a single lithography process can be performed to pattern the masks for all the openings of channel structure contacts 981, word line contacts 983, periphery contacts 985, and/or one or more ACS contacts; a single etching process can be performed to etch all the openings of channel structure contacts 981, word line contacts 983, periphery contacts 985, and/or one or more ACS contacts; a single deposition process can be performed to fill all the openings of channel structure contacts 981, word line contacts 983, periphery contacts 985, and/or one or more ACS contacts with the same conductor materials.

As shown in FIG. 9J, a plurality of first interconnect contacts 989 can be formed in filling insulating structure 947. The upper end of each first interconnect contacts 989 can be flush with one another at the top surface of filling insulating structure 947, and the lower end of each first interconnect contact 989 can be flush with one another at the bottom surface of the filling insulating structure 947, and can be in contact with the upper end of a corresponding word line contact 983, periphery contact 985, or ACS contact.

A plurality of first interconnect contacts 989 can be formed through filling insulating structure 947 by first etching vertical openings (e.g., by wet etching and/or dry etching), followed by filling the openings with conductor materials using ALD, CVD, PVD, any other suitable processes, or any combination thereof. The conductor materials used to form first interconnect contacts 989 can include, but are not limited to, W, Co, Cu, Al, polysilicon, silicides, or any combination thereof. In some implementations, other conductor materials are used to fill the openings to function as a barrier layer, an adhesion layer, and/or a seed layer. In some implementations, each first interconnect contact 989 can include multiple sub-contacts formed in the multiple sub-layers. For example, the multiple sub-contacts can include one or more contacts, single-layer/multi-layer vias, conductive lines, plugs, pads, and/or any other suitable conductive structures that are made by conductive materials including, but not limited to, W, Co, Cu, Al, doped silicon, silicides, or any combination thereof, and can be formed in multiple contact forming processes. For example, fabrication processes to form the multiple sub-contacts can include forming one or more conductive layers and one or more contact layers in the corresponding sub-layers of filling insulating structure 947. The conductive layers and the conductor contact layers can be formed by any suitable known back-end-of-line (BEOL) methods. In some implementations, all first interconnect contacts 989 can be simultaneously formed in the same contact forming processes. In some implementations, first interconnect contacts 989 can be used for connecting channel structure contacts 981, word line contacts 983, periphery contacts 985, and/or one or more ACS contacts in subsequent processes.

Referring to FIG. 8B, method 800B starts at operation 821, in which a second semiconductor structure including a second periphery circuit and a plurality of second interconnect contacts on a second substrate are formed.

In some implementations, second substrate 1010 can be any suitable semiconductor substrate having any suitable structure, such as a monocrystalline single-layer substrate, a polycrystalline silicon (polysilicon) single-layer substrate, a polysilicon and metal multi-layer substrate, etc.

In some implementations, as illustrated in FIG. 10A, second periphery circuit 1020 can be formed on second substrate 1010 using a plurality of processes including, but not limited to, photolithography, etching, thin film deposition, thermal growth, implantation, chemical mechanical polishing (CMP), and any other suitable processes. In some implementations, second periphery circuit 1020 includes a plurality of transistors 1022 that are separated from each other by STIs (not shown) formed by wet etching and/or dry etching and thin film deposition. In some implementations, second periphery circuit 1020 includes LLV circuits 402, and transistors 1022 include LLV transistors. In some implementations, second periphery circuit 1020 includes LLV circuits 402 and LV circuits 404, and transistors 1022 further include LV transistors. In some implementations, doped regions (e.g., wells, sources, and drains of transistors 1022, not shown) can be formed on or in second substrate 1010 by ion implantation and/or thermal diffusion, which function, for example, as source regions and/or drain regions of transistors 1022. Corresponding transistor contacts (e.g., gate contact, source contact, and drain contact) can be formed in an insulating layer 1050 covering second substrate 1010.

In some implementations, insulating layer 1050 can include any suitable insulating material and/or dielectric material, such as silicon oxide, etc. In some implementations as shown in FIG. 10A, insulating layer 1050 can be an oxide layer deposited on second substrate 1010 and covering second periphery circuit 1020.

A plurality of second interconnect contacts 1040 can be formed through insulating layer 1050 by first etching vertical openings (e.g., by wet etching and/or dry etching), followed by filling the openings with conductor materials using ALD, CVD, PVD, any other suitable processes, or any combination thereof. The conductor materials used to form second interconnect contacts 1040 can include, but are not limited to, W, Co, Cu, Al, polysilicon, silicides, or any combination thereof. In some implementations, other conductor materials are used to fill the openings to function as a barrier layer, an adhesion layer, and/or a seed layer. In some implementations, each second interconnect contact 1040 can include multiple sub-contacts formed in the multiple sub-layers. For example, the multiple sub-contacts can include one or more contacts, single-layer/multi-layer vias, conductive lines, plugs, pads, and/or any other suitable conductive structures that are made by conductive materials including, but not limited to, W, Co, Cu, Al, doped silicon, silicides, or any combination thereof, and can be formed in multiple contact forming processes. For example, fabrication processes to form the multiple sub-contacts can include forming one or more conductive layers and one or more contact layers in the corresponding sub-layers of insulating layer 1050. The conductive layers and the conductor contact layers can be formed by any suitable known back-end-of-line (BEOL) methods. In some implementations, all second interconnect contacts 1040 can be simultaneously formed in the same contact forming processes. In some implementations, second interconnect contacts 1040 can be used for connecting transistors 1022 in subsequent processes.

Referring back to FIG. 8B, method 800B can then proceed to operation 823, in which the first semiconductor structure and the second semiconductor structure are bonded in a face-to-face manner.

The bonding can include hybrid bonding. As illustrated in FIG. 10A, second substrate 1010 and components formed thereon (e.g., second periphery circuit 1020 and second interconnect contacts 1040) are flipped upside down. As such, first semiconductor structure 900 and second semiconductor structure 1000 can be bonded together in a face-to-face manner at bonding interface 1060, according to some implementations. In some implementations, a treatment process, e.g., a plasma treatment, a wet treatment, and/or a thermal treatment, is applied to the bonding surfaces of first semiconductor structure 900 and second semiconductor structure 1000 prior to the bonding. After the bonding, corresponding first inter interconnect contacts 989 and second interconnect contacts 1040 are aligned and in contact with one another, such that memory stack 970 and channel structures 950 can be electrically connected to first periphery circuit 920 and second periphery circuit 1020.

Referring back to FIG. 8B, method 800B proceeds to operation 825, in which part of the first substrate, part of the sacrificial stack, and part of the channel structure are sequentially removed to expose part of the semiconductor channels of the channel structures. The removal can be performed from the backside of the second substrate.

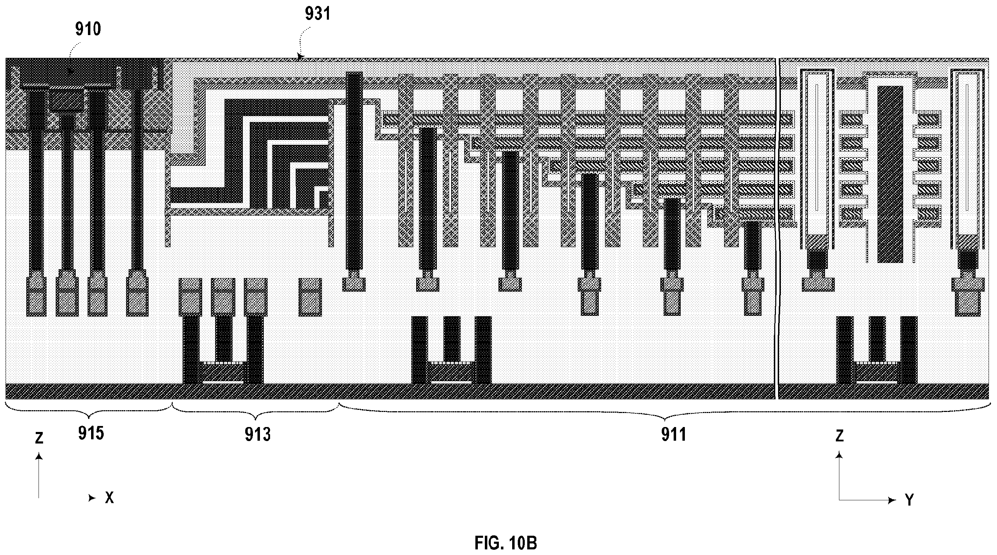

As shown in FIG. 10B, in some implementations, the bonded 3D structure can be flipped upside down, such that first semiconductor structure 900 is located below second semiconductor structure 1000 to expose the backside of first substrate 910. Portions of first substrate 910 in core region 911 and spacer region 913 can be removed from the backside until being stopped by first stop layer 931. The portions of first substrate 910 in core region 911 and spacer region 913 can be removed using CMP, grinding, dry etching, and/or wet etching. In some implementations in which first substrate 910 includes silicon and first stop layer 931 includes silicon nitride, the portions of first substrate 910 in core region 911 and spacer region 913 can be removed using silicon CMP, which can be automatically stopped when reaching first stop layer 931 having materials other than silicon, i.e., acting as a backside CMP stop layer. In some implementations, the portions of first substrate 910 in core region 911 and spacer region 913 can be removed using wet etching by tetramethylammonium hydroxide (TMAH), which is automatically stopped when reaching first stop layer 931 having materials other than silicon, i.e., acting as a backside etch stop layer. First stop layer 931 can ensure the removal of the portions of first substrate 910 in core region 911 and spacer region 913 without affecting the portions of first substrate 910 in periphery region 915 and the concern of thickness uniformity after thinning.

In some implementations, after removing the portions of first substrate 910 in core region 911 and spacer region 913, portions of sacrificial stack 930 in core region 911 can be removed to expose portions of channel structures 950. The process can include the following steps.

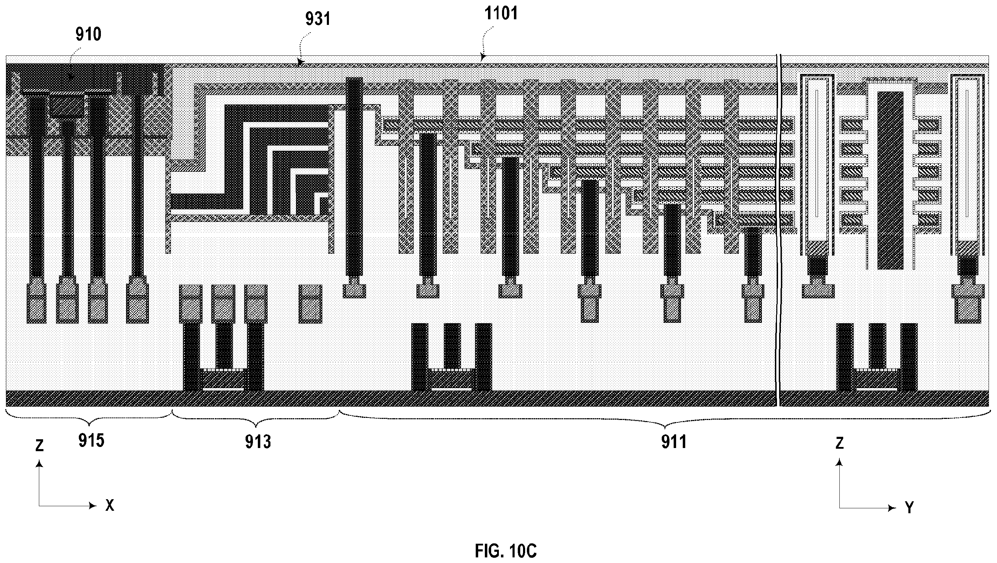

As shown in FIG. 10C, in some implementations, after removing the portions of first substrate 910 in core region 911 and spacer region 913, a protection layer 1101, such as a tetraethyl orthosilicate (TEOS) silicon oxide layer, can be deposited to cover the remaining portions of first substrate 910 in periphery region 915 and first stop layer 931 in core region 911 and spacer region 913.

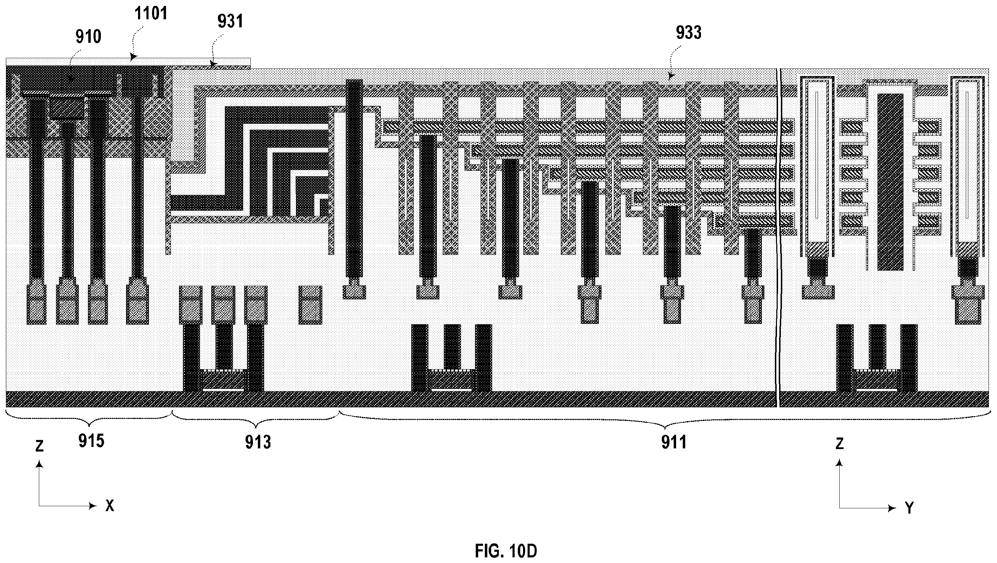

As shown in FIG. 10D, portions of protection layer 1101 and first stop layer 931 in core region 911 can be removed using wet etching with suitable etchants, such as phosphoric acid and hydrofluoric acid, until being stopped by sacrificial semiconductor layer 933 having a different material (e.g., silicon) from oxide material of protection layer 1101 and first stop layer 931. As such, portions of sacrificial semiconductor layer 933 in core region 911 can be exposed as shown in FIG. 10D. The remaining portions of protection layer 1101 in periphery region 915 can be used to protect first substrate 910 in periphery region 915 in the subsequent processes. It is noted that, portions of protection layer 1101 and first stop layer 931 in spacer region 913 can be partially or completely removed during the above process to increase over etching tolerance.

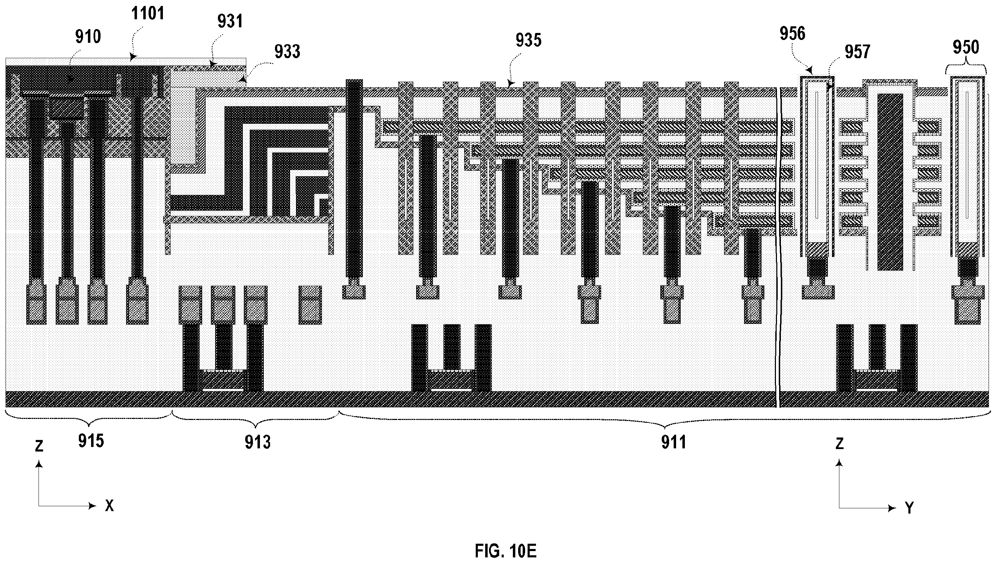

As shown in FIG. 10E, in some implementations, portions of sacrificial semiconductor layer 933 in core region 911 can be removed to expose portions of channel structure 950. For example, using the remaining portions of protection layer 1101 and first stop layer 931 in periphery region 915 and spacer region 913 as a mask, portions of sacrificial semiconductor layer 933 in core region 911 can be completed removed by a selective wet etching, and stopping at second stop layer 935. Portions of channel structure 950 extended above second stop layer 935 can be exposed.

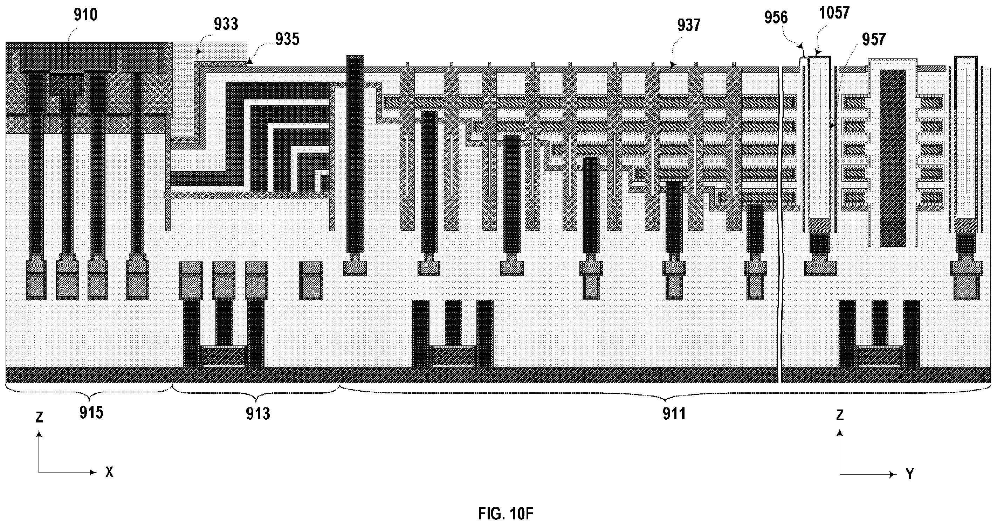

As shown in FIG. 10F, in some implementations, portions of functional layer 956 of each channel structure 950, portions of second stop layer 935 in core region 911, and protection layer 1101 in periphery region 915 can be removed. For example, a selective wet etching process can be performed to simultaneously remove protection layer 1101 in periphery region 915, portions of blocking layer 951, storage layer 953, and tunneling layer 955 that extend above barrier layer 937, and second stop layer 935 in core region 911. The etching process can be controlled by controlling the etching time and/or etching rate, such that the etching does not continue beyond barrier layer 937 into memory stack 970. As such, an upper portion of semiconductor channel 957 of each channel structure 950 can be exposed.

Referring back to FIG. 8B, method 800B proceeds to operation 827, in which the upper portions of the semiconductor channel of each channel structure can be doped, and a supplemental semiconductor layer can be formed to electrically connect with the doped semiconductor channel of each channel structure. It is noted that, an activation process can then be performed to the supplemental semiconductor layer to transform amorphous silicon material to polycrystalline silicon material.

As shown in FIG. 10F, in some implementations, the top portion 1057 of semiconductor channel 957 can be doped to increase its conductivity. For example, a tilted ion implantation (IMP) process may be performed to dope the top portion 1057 of semiconductor channel 957 (e.g., including polysilicon) with p-type dopants (e.g., boron, indium, gallium, etc.), or n-type dopants (e.g., phosphorus, arsenic, etc.), to a desired doping concentration. For p-type in-situ doping, p-type doping precursors, such as, but not limited to, diborane (B₂H₆) and boron trifluoride (BF₃), can be used. For n-type in-situ doping, n-type doping precursors, such as, but not limited to, PH₃ and AsH₃, can be used. In some implementations, after the IMP process, an array thermal treatment can be applied to the top surface of the formed 3D structure to active dopants in both doped region semiconductor channel 1057 and the doped regions of first substrate 910 (e.g., wells, sources, and drains of transistors 922) in periphery region 915.

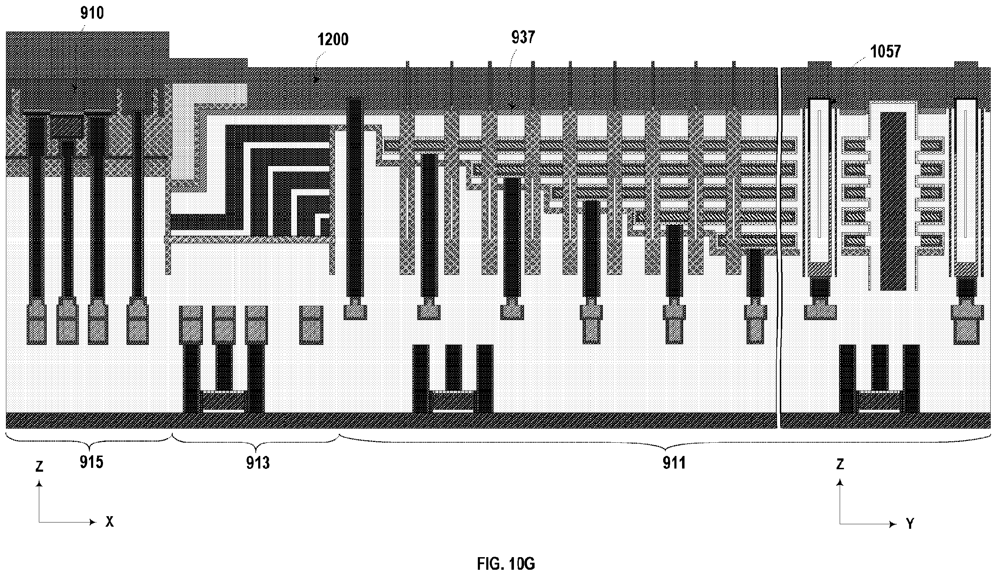

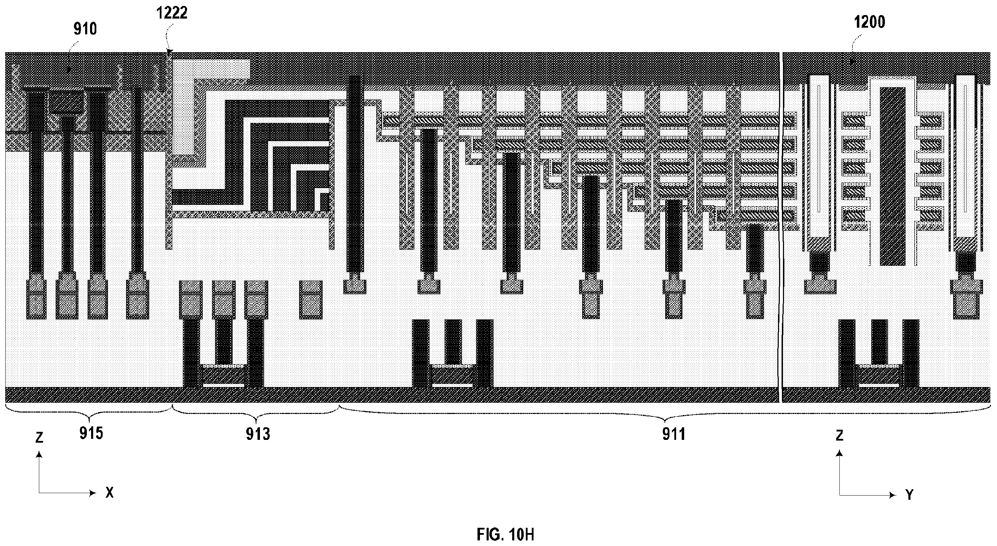

As shown in FIG. 10G, supplemental semiconductor layer 1200 can be formed in core region 911, spacer region 913, and periphery region 915. Supplemental semiconductor layer 1200 can be in electrical contact with the doped region semiconductor channel 1057 of each channel structure 950. In some implementations, supplemental semiconductor layer 1200 can be in contact with first substrate 910 in periphery region 915. In some implementations, fabricating processes of supplemental semiconductor layer 1200 can include depositing a doped amorphous silicon layer to cover the top surfaces of the 3D structure as shown in FIG. 10G, and a followed chemical mechanical polishing (CMP) process to planarize the top surfaces of the doped amorphous silicon layer as shown in FIG. 10H. After the CMP process, the remaining portion of supplemental semiconductor layer 1200 can be only in space region 913 and core region 911, and can be isolated from first substrate 910 in periphery region 915 by a spacer layer 1222.

In some implementations, an activation process can then be performed to convert the amorphous silicon material to polycrystalline silicon material. It is noted that, the activation process can be performed in one or more predetermined regions of supplemental semiconductor layer 1200 to locally activate the amorphous silicon material. In some implementations, the activation process may include a local thermal treatment, such as a laser anneal process. In some implementations, the temperature of the local thermal treatment may range from 1300 degrees Celsius to 1700 degrees Celsius. In some implementations, the laser anneal process includes a plurality of laser pulses in a laser beam, each having a pulse time of 100 ns (i.e., nanoseconds) to 300 ns.

The local thermal treatment may be confined in a desired controlled area, and would not affect other thermal-sensitive structures, such as the doped regions of first substrate 910 (e.g., wells, sources, and drains of transistors 922) in periphery region 915, thereby avoiding diffusion of implanted ions in such thermal-sensitive regions. In some implementations, the activation process may not be applied to portions of supplemental semiconductor layer 1200 corresponding to the staircase region. The doped polysilicon layer can extend at least in core region 911 and in contact with doped region semiconductor channel 1057 of each channel structure 950. Although not shown in FIG. 10H, after the activation process, supplemental semiconductor layer 1200 may still include doped amorphous silicon material in certain portions in core region 911, spacer region 913, and periphery region 915. It is noted that, the stress of the portions containing amorphous silicon material can be negative, and the stress of the portions containing polycrystalline silicon material can be positive. Such negative and positive stresses in different regions of supplemental semiconductor layer 1200 can cancel each other out. Therefore, the stress distribution can be controlled to reduce wafer stress by defining regions to be applied by the local thermal treatment. It is noted that, the specific layout of the portions containing amorphous silicon material or polycrystalline silicon material should not be limited by the implementations of the present disclosure.

Referring back to FIG. 8B, method 800B processes to operation 829, in which a pad layer can be formed on the supplemental semiconductor to electrically connect with supplemental semiconductor layer.

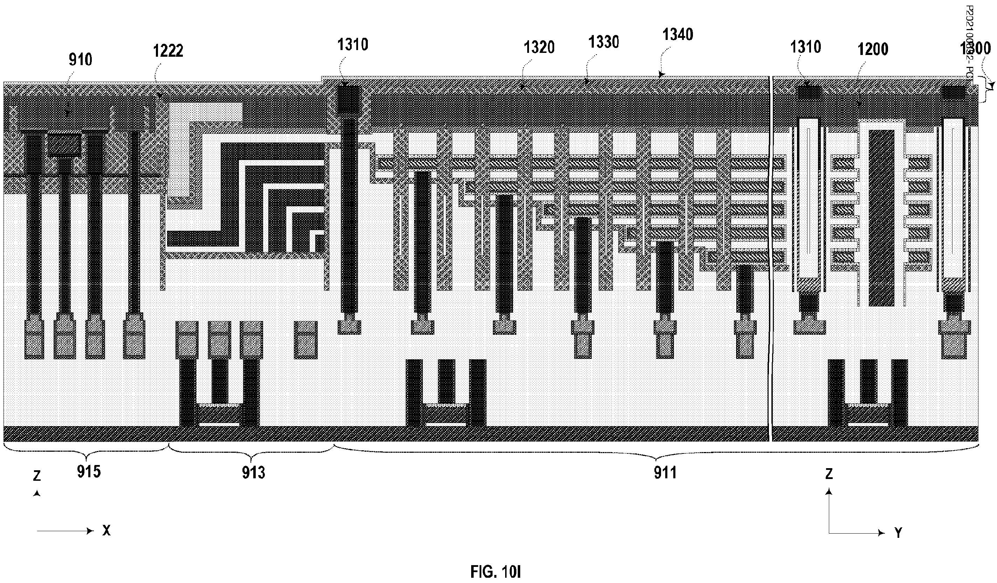

As shown in FIG. 10I, pad layer 1300 can include multiple pad structures 1310 embedded in a pad dielectric layer 1320 and in electric connection supplemental semiconductor layer 1200. In some implementations, pad layer 1300 can further include wiring layer 1330 in core region 911 on pad structures 1310 and pad dielectric layer 1320. In some implementations, pad layer 1300 can further include passivation layer 1340 in core region 911 on the wiring layer 1330, and in periphery region 915 on pad dielectric layer 1320.

Pad dielectric layer 1320 can include one or more layers of dielectric materials such as silicon oxide, silicon nitride, silicon oxynitride, or any combination thereof, and can be formed by one or more thin film deposition processes, such as ALD, CVD, PVD, any other suitable processes, or any combination thereof. In some implementations, pad dielectric layer 1320 can be formed in core region 911, spacer region 913, and periphery region 915 to cover supplemental semiconductor layer 1200. Each pad structure 1310 can be formed in pad dielectric layer 1320, and include one or more contacts, single-layer/multi-layer vias, conductive lines, plugs, pads, and/or any other suitable conductive structures that are made by conductive materials including, but not limited to, W, Co, Cu, Al, doped silicon, silicides, or any combination thereof. The upper end of each pad structure 1310 can be flush with one another at the top surface of pad dielectric layer 1320, and the lower end of each pad structure 1310 can be in contact with corresponding contacts and/or supplemental semiconductor layer 1200.

It is understood that, a contact process for forming the multiple pad structures 1310 can include multiple processes, for example, photolithography, etching, thin film deposition, and CMP. In some implementations, a hard mask layer can be formed on the pad dielectric layer 1320, and multiple vertical through openings can be formed in the pad dielectric layer 1320 by a wet etching and/or dry etching by using the hard mask layer. A followed deposition process can form the multiple pad structures 1310 by filling the multiple vertical through openings with conductor materials using ALD, CVD, PVD, any other suitable processes, or any combination thereof. The conductor materials used for filling the multiple vertical through openings can include, but are not limited to, W, Co, Cu, Al, polysilicon, silicides, or any combination thereof.

Wiring layer 1330 can be a patterned conductive layer formed on pad structures 1310 and pad dielectric layer 1320 in core region 911, as shown in FIG. 10I. In some implementations, fabricating processes of forming wiring layer 1330 can include forming a conductive layer over pad structures 1310 and pad dielectric layer 1320. After that, a resist mask is formed by a photolithography process, and an unnecessary portion is removed by etching to form wirings. In some implementations, the resist mask used for forming the wiring layer 1330 can be formed with an ink-jet method. The wiring layer 1330 can be formed with a single-layer structure or a layered structure using any of metal materials such as molybdenum (Mo), titanium (Ti), chromium (Cr), tantalum (Ta), tungsten (W), aluminum (Al), copper (Cu), neodymium (Nd), scandium (Sc), etc., and an alloy material including any of these materials as a main component. In some implementations, passivation layer 1340 can be formed to cover wiring layer 1330 in core region 911, and cover pad dielectric layer 1320 in periphery region 915 and/or spacer region 913. Passivation layer 1340 can include an insulating sublayer and a polymer sublayer. The insulating sublayer can be a nitride layer, such as a metal nitride layer. The polymer sublayer can be any suitable nanoconfinement of polymers configured to prevent scratching of or damage to the wiring layer 1330.

The foregoing description of the specific implementations can be readily modified and/or adapted for various applications. Therefore, such adaptations and modifications are intended to be within the meaning and range of equivalents of the disclosed implementations, based on the teaching and guidance presented herein.

The breadth and scope of the present disclosure should not be limited by any of the above-described exemplary implementations, but should be defined only in accordance with the following claims.

## Claims

1. A three-dimensional (3D) memory device (500), comprising:
a first semiconductor structure (510) including a core region (501), a spacer region (503), and a periphery region (505), comprising:
a memory stack (517) on a semiconductor layer (511) in the core region (501),
a first periphery circuit (513) on the semiconductor layer (511) in the periphery region (505), and
a spacer structure (515) in the spacer region (503) to separate the memory stack (517) and the first periphery circuit (513); and
a second semiconductor structure (520) including a second periphery circuit (526) on a substrate (521);
wherein the second semiconductor structure (520) is connected to the first semiconductor structure (510), wherein the memory stack (517) comprises a staircase structure (949);
**characterized in that**
the spacer structure (515) comprises a dielectric stack structure (940) in the spacer region (503), the dielectric stack structure (940) including a plurality of dielectric layer pairs each including a stack sacrificial layer (942) and a stack dielectric layer (940) different from the stack sacrificial layer (942), wherein the spacer structure (515) comprises a turning structure (945) comprising a first portion of the plurality of dielectric layer pairs extending in a horizontal plane and a second portion of the plurality of dielectric layer pairs extending in a non-horizontal plane.

2. The device of claim 1, wherein the first semiconductor structure (510) further comprises:
a plurality of channel structures (950) penetrating the memory stack (517) in the core region (501), each channel structure (950) including a functional layer (956) and a semiconductor channel (957).

3. The device of claim 2, wherein the first semiconductor structure (510) further comprises:
a plurality of dummy channel structures (959) penetrating the staircase structure (949) in the core region (501).

4. The device of claim 3, wherein the first semiconductor structure (510) further comprises:
at least one slit structure penetrating the memory stack (517) and extending in a parallel direction to separate the plurality of channel structures (950).

5. The device of claim 4, wherein the memory stack (517) comprises:
a plurality of interleaved stack dielectric layers (940) and gate structures (979) stacked in a vertical direction.

6. The device of claim 5, wherein the first semiconductor structure (510) further comprises:
a plurality of word line contacts (983), a plurality of channel structure contacts (981) in the core region (501);
a plurality of periphery contacts (985) in the periphery region (505); and
a plurality of first interconnect contacts (989) connected with corresponding word line contacts (983), channel structure contacts (981), and periphery contacts (985), respectively.

7. The device of claim 1, wherein the first periphery circuit (920) comprises:
a high voltage circuit including a plurality of high voltage transistors on the semiconductor layer (511) in the periphery region (505).

8. The device of claim 7, wherein the first periphery circuit (513) further comprises:
a low voltage circuit including a plurality of low voltage transistors on the semiconductor layer (511) in the periphery region (503).

9. The device of claim 7, wherein the second periphery circuit (526) comprises:
a low low voltage circuit including a plurality of low low voltage transistors on the substrate (521); and
a plurality of second interconnect contacts (1040) connected with corresponding low low voltage transistors, respectively.

10. The device of claim 9, wherein the second periphery circuit (526) further comprises:
a low voltage circuit including a plurality of low voltage transistors on the substrate (521).

11. The device of claim 9, wherein:
the second semiconductor structure (520) and the first semiconductor structure (510) are bonded together in a face-to-face manner, such that the second interconnect contacts (1040) and corresponding second interconnect contacts (1040) are connected respectively at a bonding interface (530).

12. The device of claim 3, wherein:
the functional layer (956) of each channel structure (981) comprises a blocking layer (951), a storage layer (953), and a tunneling layer (955); and
the semiconductor channel (957) comprises a doped region contacting the semiconductor layer (511).

13. The device of claim 3, further comprising a pad layer (1300) on the semiconductor layer (511), the pad layer (1300) comprising:
a pad dielectric layer (1320) on the semiconductor layer (511);
a plurality of pad structures (1310) embedded in the pad dielectric layer (1320);
a wiring layer (1330) on the pad dielectric layer (1320) to connect with the plurality of pad structures (1310); and
a passivation layer (1340) to cover the wiring layer (1330).

14. The device of claim 1, wherein the semiconductor layer (511) comprises:
an initial semiconductor layer in the periphery region (505); and
a supplemental semiconductor layer (1200) in the core region (501) and the spacer region (503);
wherein the initial semiconductor layer is isolated from the supplemental semiconductor layer (1200) by a spacer layer (1222).

15. A memory system, comprising:
a 3D memory device (500) according to claim 1, wherein the memory stack (517) includes an array of memory cells (206) on the semiconductor layer (511) in the core region (501), and
a memory controller (606) coupled to the memory device (500) and configured to control the array of memory cells (206) through the first peripheral circuit (513) and the second periphery circuit (526).

## Patentansprüche

1. Dreidimensionale (3D) Speichervorrichtung (500), umfassend:
eine erste Halbleiterstruktur (510) mit einem Kernbereich (501), einem Abstandshalterbereich (503) und einem Peripheriebereich (505), umfassend:
einen Speicherstapel (517) auf einer Halbleiterschicht (511) im Kernbereich (501),
eine erste Peripherieschaltung (513) auf der Halbleiterschicht (511) im Peripheriebereich (505) und
eine Abstandshalterstruktur (515) im Abstandshalterbereich zum Trennen des Speicherstapels (517) und der ersten Peripherieschaltung (513); und
eine zweite Halbleiterstruktur (520) mit einer zweiten Peripherieschaltung (526) auf einem Substrat (521);
wobei die zweite Halbleiterstruktur (520) mit der ersten Halbleiterstruktur (510) verbunden ist, wobei der Speicherstapel (517) eine Treppenstruktur (949) aufweist; **dadurch gekennzeichnet, dass**
die Abstandshalterstruktur (515) eine dielektrische Stapelstruktur (940) im Abstandshalterbereich (503) aufweist, wobei die dielektrische Stapelstruktur (940) eine Mehrzahl von dielektrischen Schichtpaaren mit jeweils einer Stapel-Opferschicht (942) und einer sich von der Stapel-Opferschicht (942) unterscheidenden Stapel-Dielektrikumschicht (940) umfasst, wobei die Abstandshalterstruktur (945) eine Drehstruktur (945) mit einem sich in einer horizontalen Ebene erstreckenden ersten Abschnitt der Mehrzahl von dielektrischen Schichtpaaren und einem sich in einer nicht horizontalen Ebene erstreckenden zweiten Abschnitt der Mehrzahl von dielektrischen Schichtpaaren umfasst.

2. Vorrichtung nach Anspruch 1, wobei die erste Halbleiterstruktur (510) ferner umfasst:
eine Mehrzahl von Kanalstrukturen (950) die den Speicherstapel (517) im Kernbereich (501) durchdringen, wobei jede Kanalstruktur (950) eine Funktionsschicht (956) und einen Halbleiterkanal (957) umfasst.

3. Vorrichtung nach Anspruch 2, wobei die erste Halbleiterstruktur (510) ferner umfasst:
eine Mehrzahl von Dummy-Kanalstrukturen (959), die die Treppenstruktur (949) im Kernbereich (501) durchdringen.

4. Vorrichtung nach Anspruch 3, wobei die erste Halbleiterstruktur (510) ferner umfasst:
mindestens eine Schlitzstruktur, die den Speicherstapel (517) durchgreift und sich in einer parallelen Richtung erstreckt, um die mehreren Kanalstrukturen (950) zu trennen.

5. Vorrichtung nach Anspruch 4, wobei der Speicherstapel (517) umfasst:
eine Mehrzahl von verschachtelten dielektrischen Schichten (940) und Gate-Strukturen (979), die in einer vertikalen Richtung gestapelt sind.

6. Vorrichtung nach Anspruch 5, wobei die erste Halbleiterstruktur (510) ferner umfasst:
eine Mehrzahl von Wortleitungskontakten (983), eine Mehrzahl von Kanalstrukturkontakten (981) im Kernbereich (501);
eine Mehrzahl von Peripheriekontakten (985) im Peripheriebereich (505); und
eine Mehrzahl von ersten Verbindungskontakten (989), die jeweils mit entsprechenden Wortleitungskontakten (983), Kanalstrukturkontakten (981) und Peripheriekontakten (985) verbunden sind.

7. Vorrichtung nach Anspruch 1, wobei die erste Peripherieschaltung (920) umfasst:
einen Hochspannungskreis mit einer Mehrzahl von Hochspannungstransistoren auf der Halbleiterschicht (511) im Peripheriebereich (505).

8. Vorrichtung nach Anspruch 7, wobei die erste Peripherieschaltung (513) ferner umfasst:
einen Niederspannungskreis mit einer Mehrzahl von Niederspannungstransistoren auf der Halbleiterschicht (511) im Peripheriebereich (503).

9. Vorrichtung nach Anspruch 7, wobei die zweite Peripherieschaltung (526) umfasst:
einen Niederspannungskreis mit einer Mehrzahl von Niederspannungstransistoren auf dem Substrat (521); und
eine Mehrzahl von zweiten Verbindungskontakten (1040), die jeweils mit entsprechenden Niederspannungstransistoren verbunden sind.

10. Vorrichtung nach Anspruch 9, wobei die zweite Peripherieschaltung (526) ferner umfasst:
einen Niederspannungskreis mit einer Mehrzahl von Niederspannungstransistoren auf dem Substrat (521).

11. Vorrichtung nach Anspruch 9, wobei:
die zweite Halbleiterstruktur (520) und die erste Halbleiterstruktur (510) mit ihren Vorderseiten aneinandergebondet sind, derart, dass die zweiten Verbindungskontakte (1040) und die korrespondierenden zweiten Verbindungskontakte (1040) jeweils an einer Bonding-Schnittstelle verbunden sind.

12. Vorrichtung nach Anspruch 3, wobei:
die Funktionsschicht (956) jeder Kanalstruktur (981) eine Sperrschicht (951), eine Speicherschicht (953) und eine Tunneling-Schicht (955) umfasst; und
der Halbleiterkanal (957) einen die Halbleiterschicht (511) kontaktierenden dotierten Bereich umfasst.

13. Vorrichtung nach Anspruch 3, ferner umfassend eine Pad-Schicht (1300) auf der Halbleiterschicht (511), wobei die Pad-Schicht (1300) umfasst:
eine Pad-Dielektrikumschicht (1320) auf der Halbleiterschicht (511);
eine Mehrzahl von Pad-Strukturen (1310) die in die Pad-Dielektrikumschicht (1320) eingebettet sind;
eine Verdrahtungsschicht (1330) auf der Pad-Dielektrikumschicht (1320) zur Verbindung mit den mehreren Pad-Strukturen (1310); und
eine Passivierungsschicht (1340) zum Abdecken der Verdrahtungsschicht (1330).

14. Vorrichtung nach Anspruch 1, wobei die Halbleiterschicht (511) umfasst:
eine initiale Halbleiterschicht im Peripheriebereich (505); und
eine ergänzende Halbleiterschicht (1200) im Kernbereich (501) und im Abstandshalterbereich (503);
wobei die initiale Halbleiterschicht durch eine Abstandshalterschicht (1222) von der ergänzenden Halbleiterschicht (1200) isoliert ist.

15. Speichersystem, umfassend:
eine 3D-Speichervorrichtung (500) nach Anspruch 1, wobei der Speicherstapel (517) eine Anordnung von Speicherzellen (206) auf der Halbleiterschicht (511) im Kernbereich (501) aufweist, und
eine Speichersteuerung (606) die mit der Speichervorrichtung (500) verbunden ist und ausgebildet ist zum Steuern der Anordnung von Speicherzellen (206) über die erste Peripherieschaltung (513) und die zweite Peripherieschaltung (526).

## Revendications

1. Dispositif de mémoire tridimensionnel (3D) (500) comprenant:
une première structure semi-conductrice (510) avec une zone centrale (501), une zone d' espacement (503) et une zone périphérique (505), comprenant:
une pile de mémoire (517) sur une couche semi-conductrice (511) dans la zone centrale (501),
un premier circuit périphérique (513) sur la couche semi-conductrice (511) dans la zone périphérique (505) et
une structure d'espacement (515) dans la zone d'espacement pour séparer la pile de mémoire (517) et le premier circuit périphérique (513); et
une deuxième structure semi-conductrice (520) avec un deuxième circuit périphérique (526) sur un substrat (521);
la deuxième structure semi-conductrice (520) étant reliée à la première structure semi-conductrice (510), la pile de mémoire (517) présentant une structure en escalier (949) ;
**caractérisé en ce que**
la structure d'espacement (515) comprend une structure de pile diélectrique (940) dans la zone d'espacement (503), la structure de pile diélectrique (940) comprenant une pluralité de paires de couches diélectriques comprenant chacune une couche sacrificielle de pile (942) et une couche diélectrique de pile (940) distincte de la couche sacrificielle de pile (942), la structure d'espacement (945) comprenant une structure de rotation (945) avec une première partie de la pluralité de paires de couches diélectriques s'étendant dans un plan horizontal et une deuxième partie de la pluralité de paires de couches diélectriques s'étendant dans un plan non horizontal.

2. Dispositif selon la revendication 1, dans lequel la première structure semi-conductrice (510) comprend en outre:
une pluralité de structures de canaux (950) pénétrant la pile de mémoire (517) dans la zone centrale (501), chaque structure de canal (950) comprenant une couche fonctionnelle (956) et un canal semi-conducteur (957).

3. Dispositif selon la revendication 2, dans lequel la première structure semi-conductrice (510) comprend en outre:
une pluralité de structures de canaux factices (959) pénétrant la structure en escalier (949) dans la zone centrale (501).

4. Dispositif selon la revendication 3, dans lequel la première structure semi-conductrice (510) comprend en outre:
au moins une structure à fente qui pénètre la pile de mémoire (517) et s'étend dans une direction parallèle afin de séparer la pluralité de structures de canaux (950).

5. Dispositif selon la revendication 4, dans lequel la pile de mémoire (517) comprend:
une pluralité de couches diélectriques imbriquées (940) et de structures de grille (979) empilées dans une direction verticale.

6. Dispositif selon la revendication 5, dans lequel la première structure semi-conductrice (510) comprend en outre:
une pluralité de contacts de ligne de mots (983), une pluralité de contacts de structure de canal (981) dans la zone centrale (501);
une pluralité de contacts périphériques (985) dans la zone périphérique (505); et
une pluralité de premiers contacts de connexion (989) connectés respectivement à des contacts de ligne de mots (983), des contacts de structure de canal (981) et des contacts périphériques (985) correspondants.

7. Dispositif selon la revendication 1, dans lequel le premier circuit périphérique (920) comprend:
un circuit haute tension comprenant une pluralité de transistors haute tension sur la couche semi-conductrice (511) dans la zone périphérique (505).

8. Dispositif selon la revendication 7, dans lequel le premier circuit périphérique (513) comprend en outre:
un circuit basse tension comprenant une pluralité de transistors basse tension sur la couche semi-conductrice (511) dans la zone périphérique (503).

9. Dispositif selon la revendication 7, dans lequel le deuxième circuit périphérique (526) comprend:
un circuit basse tension comprenant une pluralité de transistors basse tension sur le substrat (521); et
une pluralité de deuxièmes contacts de connexion (1040) connectés respectivement à des transistors basse tension correspondants.

10. Dispositif selon la revendication 9, dans lequel le deuxième circuit périphérique (526) comprend en outre:
un circuit basse tension avec une pluralité de transistors basse tension sur le substrat (521).

11. Dispositif selon la revendication 9, dans lequel:
la deuxième structure semi-conductrice (520) et la première structure semi-conductrice (510) sont bondées l'une à l'autre par leurs faces avant, de telle sorte que les deuxièmes contacts de connexion (1040) et les deuxièmes contacts de connexion correspondants (1040) sont respectivement connectés à une interface de bonding.

12. Dispositif selon la revendication 3, dans lequel:
la couche fonctionnelle (956) de chaque structure de canal (981) comprend une couche barrière (951), une couche de stockage (953) et une couche tunnel (955); et
le canal semi-conducteur (957) comprend une zone dopée en contact avec la couche semi-conductrice (511).

13. Dispositif selon la revendication 3, comprenant en outre une couche de plot (1300) sur la couche semi-conductrice (511), la couche de plot (1300) comprenant:
une couche diélectrique de tampon (1320) sur la couche semi-conductrice (511);
une pluralité de structures de tampons (1310) noyées dans la couche diélectrique de tampon (1320);
une couche de câblage (1330) sur la couche diélectrique de tampon (1320) pour la connexion à la pluralité de structures de tampon (1310); et
une couche de passivation (1340) pour recouvrir la couche de câblage (1330).

14. Dispositif selon la revendication 1, dans lequel la couche semi-conductrice (511) comprend:
une couche semi-conductrice initiale dans la zone périphérique (505); et
une couche semi-conductrice complémentaire (1200) dans la zone centrale (501) et dans la zone d'espacement (503);
la couche semi-conductrice initiale étant isolée de la couche semi-conductrice complémentaire (1200) par une couche d'espacement (1222).

15. Système de mémoire comprenant:
un dispositif de mémoire 3D (500) selon la revendication 1, dans lequel la pile de mémoire (517) comprend un réseau de cellules de mémoire (206) sur la couche semi-conductrice (511) dans la zone centrale (501), et
un contrôleur de mémoire (606) connecté au dispositif de mémoire (500) et conçu pour contrôler le réseau de cellules de mémoire (206) via le premier circuit périphérique (513) et le deuxième circuit périphérique (526).
